# EUROPEAN PATENT APPLICATION

(11) **EP 3 859 772 A1**
(43) Date of publication of application: **04.08.2021**
(21) Application number: 19866826.1
(22) Date of filing: 01.08.2019
(51) Int. Cl.: H01L 21/683, H01L 21/301

(54) **WAFER BREAKING DEVICE, INVERTING DEVICE, AND CONVEYANCE SYSTEM**

(30) Priority: 28.09.2018 JP 2018185543; 28.09.2018 JP 2018185547
(71) Applicant: Mitsuboshi Diamond Industrial Co., Ltd., Settsu, Osaka 566-0034 (JP)
(72) Inventor: MITANI, Takuro, Settsu city, Osaka 5660034 (JP); TOKIMOTO, Ikuo, Settsu city, Osaka 5660034 (JP); KANEHIRA, Yuichi, Settsu city, Osaka 5660034 (JP); OKUDA, Osamu, Settsu city, Osaka 5660034 (JP)
(74) Representative: TBK
(86) International application number: PCT/JP2019/030169
(87) International publication number: WO 2020/066285

(57) **Abstract**

A wafer breaking apparatus 1 including: a scribe unit 20 configured to form a scribe line on a surface WA of a wafer W; a film laminating unit 30 configured to attach a film 31 to the surface WA, of the wafer W, on which the scribe line has been formed; an inverting unit 100 configured to invert the W wafer such that a face thereof to which the film 31 has been attached is on a lower side; a break unit 40 configured to break the wafer W along the scribe line by applying a predetermined force to a face, of the wafer, to which the film 31 has not been attached; and a conveyance part 200 configured to convey the wafer W to a predetermined position, wherein the film laminating unit 30 is disposed at a position separated in a vertical direction from the inverting unit 100.

## Description

### TECHNICAL FIELD

The present invention relates to a breaking apparatus that breaks a wafer, an inverting apparatus that inverts a wafer, and a conveyance system in which a wafer is conveyed.

### BACKGROUND ART

To date, breaking of a brittle material substrate such as a glass substrate or a semiconductor wafer is performed through a scribing step of forming a scribe line on a surface of a substrate, a breaking step of breaking the substrate by applying a predetermined force on the substrate along the scribe line, and the like. In the scribing step, while the blade edge of a scribing wheel is pressed against the surface of the substrate, the blade edge is moved along a predetermined line. After the scribing step, the substrate is inverted such that the front and back faces thereof are reversed, and a breaking step is performed.

PATENT LITERATURE 1 below discloses a scriber apparatus for executing a scribing step on a wafer. In this apparatus, the wafer is attached to a surface of a dicing tape attached to an annular frame. The wafer is placed on a suction chuck of a chuck table of the scriber apparatus, and the wafer is suctioned and held via the dicing tape by the suction chuck. Then, a roller scriber is positioned by pressing means at one end of a line for division of the wafer, and the roller scriber applies a predetermined pressure on the wafer. In this state, when the chuck table is moved in a predetermined direction, a scribe line is formed at the line for division. The above step is repeatedly performed, whereby scribe lines are formed at lines for division of the wafer.

### CITATION LIST

### [PATENT LITERATURE]

[PTL 1] Japanese Laid-Open Patent Publication No. 2012-146879

### SUMMARY OF THE INVENTION

### PROBLEMS TO BE SOLVED BY THE INVENTION

In PATENT LITERATURE 1, the wafer having scribe lines formed thereon is conveyed to another stage for a breaking step. Here, when the breaking step is to be performed, a step of attaching a protection film to the face where the scribe lines are formed, and a step of inverting the wafer such that the front and back faces thereof are reversed are performed. When the scribing step is performed by the scriber apparatus of PATENT LITERATURE 1, every time each step as described above is performed on the wafer, the wafer has to be conveyed to a predetermined stage, which cannot be said as being good in wafer breaking efficiency.

Thus, it is conceivable to configure an apparatus that includes all of the apparatuses that execute the respective steps described above. However, when a single apparatus is formed by simply arranging the apparatuses, the apparatus is increased in size. In addition, when the conveyance route of the wafer is complicated, conveyance is not performed smoothly, which results in a lowered operating rate per installation area of the apparatus.

In consideration of the above problem, an object of the present invention is to provide a wafer breaking apparatus that can suppress increase in the installation area of the apparatus and that can improve the operating rate per installation area of the apparatus, an inverting apparatus that inverts a wafer applied to the wafer breaking apparatus, and a conveyance system in which a wafer is conveyed.

### SOLUTION TO THE PROBLEMS

A first mode of the present invention relates to a wafer breaking apparatus configured to break a wafer. The wafer breaking apparatus according to the present mode includes: a scribe unit configured to form a scribe line on a surface of a wafer; a film laminating unit configured to attach a film to the surface, of the wafer, on which the scribe line has been formed; an inverting unit configured to invert the wafer such that a face, of the wafer, to which the film has been attached is on a lower side; a break unit configured to break the wafer along the scribe line by applying a predetermined force to a face, of the wafer, to which the film has not been attached; and a conveyance part configured to convey the wafer to a predetermined position. The film laminating unit is disposed at a position separated in a vertical direction from the inverting unit.

Usually, the film laminating unit has a larger area than the scribe unit and the break unit. Thus, when the film laminating unit is disposed on the same plane as the scribe unit, etc., the installation area of the entire apparatus is increased. Therefore, instead of arranging all units on a plane, when the film laminating unit having a large area is disposed so as to be separated from the inverting unit in the vertical direction, the installation area of the apparatus can be reduced. In this arrangement, a conveyance path for conveying a wafer to the film laminating unit need not be provided on the plane. Thus, the installation area can be further reduced by the area corresponding to members related to such a conveyance path. Accordingly, the operating rate per installation area of the apparatus can be improved.

Breaking of a wafer is performed on a face where scribe lines are not formed, i.e., on a face to which the film is not attached. Therefore, before breaking of the wafer is performed, the wafer needs to be inverted.

Thus, when the film laminating unit is disposed at a position separated in the vertical direction from the inverting unit, the film laminating unit and the inverting unit are arranged on one straight line. Thus, the route for conveying the wafer can be simplified. Therefore, the wafer can be efficiently conveyed from the film laminating unit to the inverting unit.

In the wafer breaking apparatus according to the present mode, the wafer may be sent to a delivery position provided at a position, in a plan view, that is between the scribe unit and the break unit and that is overlapped by the inverting unit, and the conveyance part may include a raising/lowering portion configured to convey the wafer positioned at the delivery position to the film laminating unit, and further configured to convey the wafer from the film laminating unit to the inverting unit.

In the step related to breaking of a wafer, scribe lines are formed by the scribe unit, the film is attached by the film laminating unit to the face on which the scribe lines have been formed, the wafer is inverted by the inverting unit such that the front and back faces thereof are reversed, and then breaking of the wafer is performed by the break unit. In this case, when the delivery position is provided at the above-described position, and the raising/lowering portion is used in conveyance to the film laminating unit and to the inverting unit, the wafer can be directly conveyed to the intended unit without via another unit. Therefore, the time required in conveyance of the wafer is shortened, and the operating rate per installation area of the apparatus is improved.

Since the wafer is conveyed, starting from the delivery position, to the scribe unit and the break unit, the conveyance route in a plan view can be shortened. Accordingly, the installation area of the apparatus is reduced, and the operating rate per installation area of the apparatus can be further improved.

The inverting unit may be configured to, while inverting the wafer to which the film has been attached by the film laminating unit, convey the wafer to the delivery position.

With this configuration, the inverting unit performs inversion of the wafer and conveyance of the wafer in the vertical direction to the delivery position. Thus, the wafer can be efficiently conveyed to the delivery position through a short conveyance route.

In this case, the wafer broken by the break unit is conveyed via the delivery position to a position at which conveyance of the wafer has been started.

When a plurality of conveyance routes are used, members such as a rail and the like need to be provided for each route, which results in increase in the installation area of the entire apparatus. With this configuration, the conveyance route can be used in common before and after the breakage of the wafer. Therefore, the area required for provision of the conveyance route can be suppressed, and thus, the installation area of the apparatus can be reduced.

In the wafer breaking apparatus according to the present mode, the inverting unit may be disposed above the delivery position.

With this configuration, the wafer to which the film has been attached can be conveyed in a conveyance route in a single direction extending downwardly. In addition, when the wafer is conveyed downwardly, the wafer can be positioned to the delivery position also due to gravity. Therefore, conveyance of the wafer from the inverting unit to the delivery position can be smoothly and efficiently performed.

In the wafer breaking apparatus according to the present mode, the film laminating unit may be disposed above the inverting unit.

With this configuration, the wafer is conveyed from the film laminating unit at an upper position to the inverting unit at a lower position, and further, the wafer is conveyed to the delivery position provided immediately below the inverting unit. In this manner, the conveyance route from the film laminating unit to the delivery position can be implemented as a conveyance route in a single direction extending downwardly. Thus, conveyance of the wafer from the film laminating unit to the inverting unit and from the inverting unit to the delivery position can be smoothly and efficiently performed.

In the wafer breaking apparatus according to the present mode, the inverting unit may include: a holding part configured to hold the wafer; and a rotation drive part configured to move the holding part in a linear direction while rotating the holding part. The rotation drive part may drive the holding part such that the wafer is rotated such that front and back faces thereof are reversed while the wafer is making an arc-shaped trajectory, between a reception position at which the holding part receives the wafer and an inversion completion position that is separated in the linear direction from the reception position and at which inversion of the wafer is completed.

According to this configuration, after the holding part has received the wafer at the reception position, the holding part is positioned to the inversion completion position while being inverted by the rotation drive part. This eliminates the need of performing a step of temporarily placing the wafer received by the holding part, a step of rotating the wafer, and a step for conveying the inverted wafer to an intended place, for example. Thus, the inversion of the wafer can be efficiently performed. In addition, with this configuration, the wafer, while being inverted, can be transferred to an intended position. Thus, the inversion operation of the wafer can be performed in a still smaller space, and thus, the installation area of the wafer breaking apparatus can be reduced.

In the wafer breaking apparatus according to the present mode, the rotation drive part may include: a support member configured to rotatably support the holding part; a pinion gear mounted to a rotation shaft of the holding part; a rack gear meshed with the pinion gear and extending in the linear direction; and a drive mechanism configured to move the support member in the linear direction.

According to this configuration, when the support member has been moved in the linear direction by the drive mechanism, the pinion gear and the rack gear perform relative movement in the linear direction. Accordingly, the pinion gear is rotated on the rack gear, and in association with this, the holding part is rotated. Thus, with this simple configuration obtained by combining the rack gear and the pinion gear, the holding part can be moved in the linear direction while being rotated.

In the wafer breaking apparatus according to the present mode, the wafer taken out of the storage part may be sent to a delivery position provided at a position, in a plan view, that is between the scribe unit and the break unit and that is overlapped by the inverting unit; after the wafer has been transferred from the reception position to the inversion completion position, the drive mechanism may further move the support member by a predetermined number of strokes to transfer the wafer to the delivery position separated in the linear direction from the inversion completion position; and the wafer breaking apparatus may further include an adjustment mechanism configured to move the rack gear in the linear direction in association with the movement of the support member by the predetermined number of strokes.

In general, a semiconductor wafer is a thin film, and is weak to impact. Therefore, when the substrate comes into contact with a member at the delivery position during inversion operation, the wafer could be damaged by the impact.

In this regard, with this configuration, since the second position and the delivery position are separated from each other, during rotation of the substrate, the wafer is assuredly prevented from coming into contact with the member at the delivery position and being damaged. In addition, while the substrate is transferred from the inversion completion position to the delivery position, the rack gear is moved in association with the movement of the support member, and thus, no relative movement is caused between the rack gear and the pinion gear. Therefore, further rotation of the substrate does not occur during the movement from the inversion completion position to the delivery position. Accordingly, the wafer can be smoothly moved from the inversion completion position to the delivery position.

In this case, the adjustment mechanism may include: a moving member coupled to the rack gear; a guide configured to support the moving member so as to be movable in a sliding manner in the linear direction; a biasing member configured to bias the moving member in a direction from the inversion completion position toward the reception position; and a sending mechanism configured to move the moving member against the biasing by the biasing member during the movement of the support member by the predetermined number of strokes.

According to this configuration, when the wafer is transferred from the inversion completion position to the delivery position, the moving member and the rack gear can be smoothly moved in an integrated manner by the sending mechanism.

The sending mechanism may include: a contacted part provided to the moving member; and a contacting part provided to the support member and opposed to the contacted part in the linear direction. During the movement of the support member by the predetermined number of strokes, the contacting part may come into contact with the contacted part, the moving member may receive a pressing force from the support member, and due to the pressing force, the moving member may be moved against the biasing in association with the movement of the support member.

According to this configuration, since the sending mechanism is composed of the contacted part provided to the moving member and the contacting part provided to the support member, there is no need to provide a complicated mechanism. Therefore, with a very simple configuration, the moving member and the rack gear can be moved in association with the movement of the support member from the inversion completion position to the delivery position.

In this configuration, the biasing member may be an air cylinder.

When an air cylinder is used as the biasing member, biasing of the moving member can be smoothly controlled. Therefore, the moving member and the rack gear can be smoothly and stably moved in association with the movement of the support member from the inversion completion position to the delivery position.

In the inverting apparatus according to the present mode, the reception position may be at an upper position in the vertical direction relative to the inversion completion position.

With this configuration, the substrate can be smoothly inverted while being moved downwardly.

In the wafer breaking apparatus according to the present mode, the holding part may include: a suction portion configured to suction the wafer; a lever mounted to the rotation shaft; and a holding member coupled to the lever and configured to hold the suction portion.

According to this configuration, the wafer is moved while being rotated in a shape of an arc having a radius based on the length of the lever. Thus, when the holding part has been rotated by 90° from the reception position, a space is generated between the reception position and the inversion completion position. Therefore, the wafer of which inversion has been completed can be conveyed by causing an apparatus such as the sending-out part to pass through this space.

In the wafer breaking apparatus according to the present mode, the holding part may include: a suction portion configured to suction the wafer; and a holding member mounted to the rotation shaft and configured to hold the suction portion.

According to this configuration, the holding member is directly mounted to the rotation shaft. Thus, the substrate is moved while being rotated in a shape of a small arc. Therefore, the size of the inverting unit can be reduced, and the size of the wafer breaking apparatus can be reduced.

In the wafer breaking apparatus according to the present mode, the conveyance part may include a conveyance member configured to be raised/lowered in the linear direction, and when the holding part is at a position to which the holding part has been rotated by 90° from the reception position, the conveyance member may pass between the reception position and the inversion completion position in the linear direction.

According to this configuration, the wafer is moved while being rotated in a shape of an arc having a radius based on the length of the lever. Thus, when the holding part has been rotated by 90° from the reception position, a space is generated between the reception position and the inversion completion position. Therefore, the wafer of which inversion has been completed can be conveyed by causing the conveyance member to pass through this space.

A second mode of the present invention relates to an inverting apparatus configured to invert a substrate. An inverting apparatus according to the present mode includes: a holding part configured to hold the wafer; and a rotation drive part configured to move the holding part in a linear direction while rotating the holding part. The rotation drive part drives the holding part such that the wafer is rotated such that front and back faces thereof are reversed while the wafer is making an arc-shaped trajectory, between a reception position at which the holding part receives the wafer and an inversion completion position that is separated in the linear direction from the reception position and at which inversion of the wafer is completed.

According to this configuration, effects similar to those in the first mode are exhibited.

A third mode of the present invention relates to a conveyance system configured to convey a wafer. The conveyance system according to the present mode includes:
an inverting apparatus including a holding part configured to hold the wafer and a rotation drive part configured to move the holding part in a linear direction while rotating the holding part, the rotation drive part being configured to drive the holding part such that the wafer is rotated such that front and back faces thereof are reversed while the wafer is making an arc-shaped trajectory, between a reception position at which the holding part receives the wafer and an inversion completion position that is separated in the linear direction from the reception position and at which inversion of the wafer is completed; and a conveyance part configured to convey the wafer to the inverting apparatus.

According to this configuration, effects similar to those in the first mode are exhibited.

### ADVANTAGEOUS EFFECTS OF THE INVENTION

As described above, according to the present invention, a wafer breaking apparatus that can suppress increase in the installation area of the apparatus and that can improve the operating rate per installation area of the apparatus, an inverting apparatus that inverts a wafer applied to the wafer breaking apparatus, and a conveyance system in which the wafer is conveyed, can be provided.

The effects and the significance of the present invention will be further clarified by the description of the embodiment below. However, the embodiment below is merely an example for implementing the present invention. The present invention is not limited by the embodiment below in any way.

### BRIEF DESCRIPTION OF THE DRAWINGS

[FIG. 1] FIG. 1 is a perspective view showing an external configuration of a wafer breaking apparatus according to an embodiment.
[FIG. 2] FIG. 2 is a perspective view showing an external configuration of the wafer breaking apparatus according to the embodiment.
[FIG. 3] FIGS. 3(a) and 3(b) are each a schematic diagram for describing conveyance of a wafer in the wafer breaking apparatus according to the embodiment.
[FIG. 4] FIG. 4 is a perspective view showing a configuration of an inverting unit of the wafer breaking apparatus according to the embodiment.
[FIG. 5] FIG. 5 is a perspective view showing a configuration of the inverting unit of the wafer breaking apparatus according to the embodiment.
[FIG. 6] FIGS. 6(a) to 6(c) are each a schematic diagram showing inversion operation of a wafer performed by the inverting unit of the wafer breaking apparatus according to the embodiment.
[FIG. 7] FIG. 7 shows how a wafer is inverted by the inverting unit of the wafer breaking apparatus according to the embodiment.
[FIG. 8] FIGS. 8(a) and 8(b) are each a perspective view for describing placement of a wafer performed by the inverting unit of the wafer breaking apparatus according to the embodiment.
[FIG. 9] FIG. 9(a) is a perspective view showing a configuration of a first conveyance portion of the wafer breaking apparatus according to the embodiment. FIG. 9(b) is a perspective view showing configurations of a second conveyance portion and a third conveyance portion of the wafer breaking apparatus according to the embodiment.
[FIG. 10] FIG. 10 is a perspective view showing a configuration of a raising/lowering portion of the wafer breaking apparatus according to the embodiment.
[FIG. 11] FIG. 11 is a schematic diagram showing arrangement of the inverting unit and the raising/lowering portion of the wafer breaking apparatus according to the embodiment.
[FIG. 12] FIG. 12 is a block diagram showing a configuration of the wafer breaking apparatus according to the embodiment.
[FIG. 13] FIG. 13 is a flow chart of operation of the wafer breaking apparatus according to the embodiment.
[FIG. 14] FIG. 14 is a block diagram showing a configuration of the inverting unit according to the embodiment.
[FIG. 15] FIG. 15 is a flow chart of operation of the inverting unit according to the embodiment.

### BEST MODE FOR CARRYING OUT THE INVENTION

Hereinafter, an embodiment of the present invention will be described with reference to the drawings. For convenience, in the drawings, an X axis, a Y axis, and a Z axis orthogonal to one another are indicated. The X-Y plane is parallel to the horizontal plane, and the Z-axis direction is the vertical direction. The Z-axis positive side is the upper side and the Z-axis negative side is the lower side.

### <Embodiment>

A semiconductor device widely used in electronic instruments and the like is produced from a semiconductor wafer that is sectioned into a plurality of regions and in which an optical device or the like is incorporated in each region. A wafer breaking apparatus according to the present embodiment is an apparatus that breaks a semiconductor wafer along predetermined lines that section the regions.

Examples of the material of the semiconductor wafer include single crystal silicon (Si), silicon carbide (SiC), gallium nitride (GaN), and gallium arsenide (GaSa). The material as above, the thickness, and the size of the semiconductor wafer are appropriately selected and designed in accordance with the type, the function, and the like of the intended semiconductor device to be produced.

Next, units that form the wafer breaking apparatus according to the present embodiment, and a layout in which the units are arranged in an optimum manner are described. The wafer breaking apparatus according to the present embodiment breaks a semiconductor wafer having a dicing tape attached to an annular frame therefor. Hereinafter, the "semiconductor wafer having a dicing tape attached to an annular frame therefor" will be simply expressed as a "wafer W". The surface of the wafer W is provided with predetermined grid-like lines in advance. The wafer breaking apparatus forms scribe lines on the surface of the wafer along the predetermined lines, and then, breaks the semiconductor wafer along the scribe lines.

### [Configuration of wafer breaking apparatus]

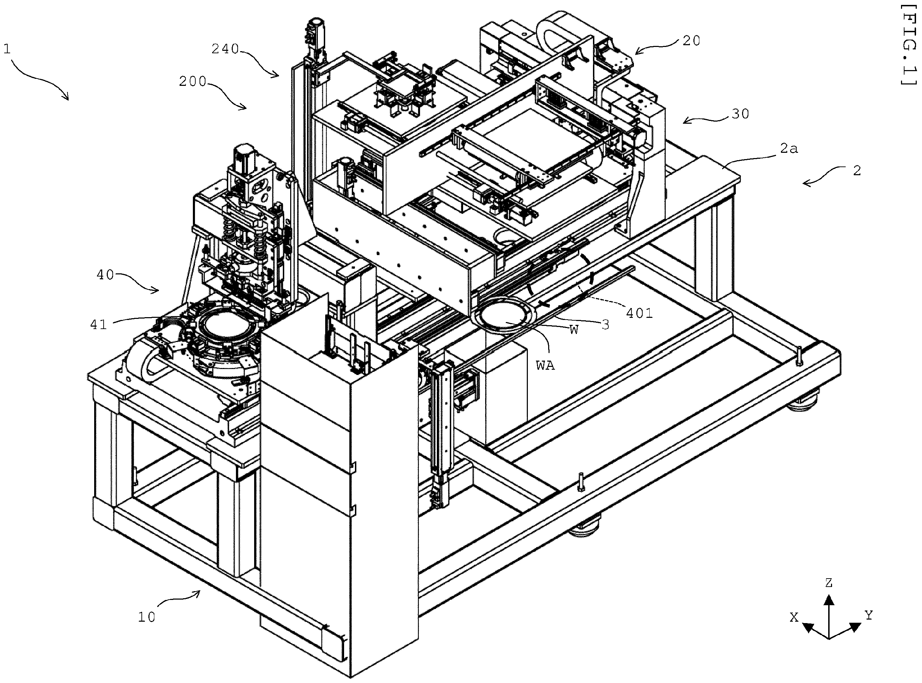

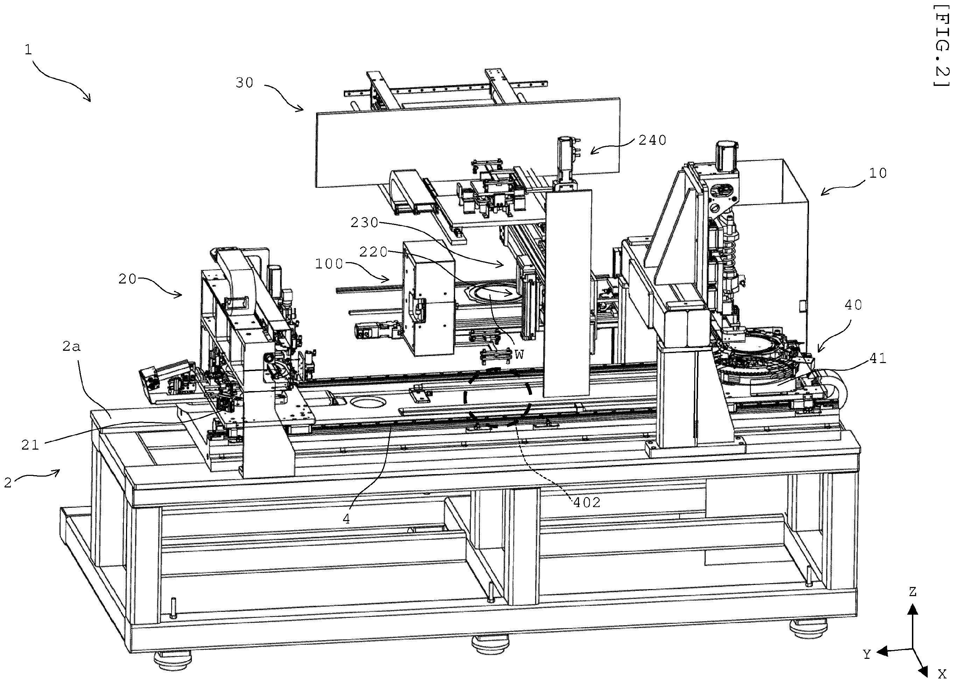

FIG. 1 and FIG. 2 are each a perspective view showing an external configuration of a wafer breaking apparatus 1 according to the present embodiment. As shown in FIG. 1 and FIG. 2, the wafer breaking apparatus 1 includes a rack 2, a first conveyance rail 3, a second conveyance rail 4, a storage part 10, a scribe unit 20, a film laminating unit 30, a break unit 40, an inverting unit 100, and a conveyance part 200.

The rack 2 is a base that supports the wafer breaking apparatus 1. The first conveyance rail 3 and the second conveyance rail 4 are provided on the Y-axis positive and negative sides, and are rails for conveying the wafer W.

The storage part 10 stores a plurality of semiconductor wafers W. Although the specific configuration of the storage part 10 is not described, the storage part 10 may be provided with, for example, a plurality of grooves at equal intervals in the inner wall of the storage part 10 so that the storage part 10 can store wafers W stacked along these grooves. The storage part 10 is provided with a door (not shown) on the Y-axis positive side in FIG. 1, and when this door is open, a wafer W is taken out by a sending-in part (not shown), and is conveyed to a predetermined position along the first conveyance rail 3.

In the present embodiment, the storage part 10 is provided to the wafer breaking apparatus 1. However, without the storage part 10 being provided, wafers W may be sent one by one to the apparatus by an operator or a robot, for example.

The scribe unit 20 forms scribe lines along predetermined lines provided in advance on a surface WA of a semiconductor wafer W. As the scribe unit 20, a scribe unit that is usually used when forming scribe lines on a brittle material substrate such as a glass substrate, can be used.

The scribe unit 20 may be configured as below, for example. A wafer W is placed on a scribe table 21 such that the surface WA of the wafer W is positioned on the upper side. The scribe unit 20 is provided with a scribe head that holds a scribing wheel, and the scribe head can be moved in the X-axis direction so as to be freely positioned. When a scribing wheel (not shown) is positioned at one end of a predetermined line provided on the surface WA, and a predetermined pressure is applied, the blade edge of the scribing wheel comes into contact with the surface WA of the wafer W, whereby a predetermined load is applied to the wafer W. In this state, when the scribe head is driven, the scribing wheel forms a scribe line in one direction along the X axis and returns to the original position. This is performed at predetermined intervals in the Y-axis direction, whereby scribe lines are formed by the scribing wheel along predetermined lines.

The predetermined lines provided on the wafer W are usually in a grid-like shape. A plurality of scribe lines are formed in the above-described procedure, and then, the scribe table 21 is rotated by 90° to form scribe lines in the same manner as in the above-described procedure, whereby grid-like scribe lines can be formed.

In the wafer breaking apparatus 1 according to the present embodiment, the scribe unit 20 is disposed on the X-axis positive side of the wafer breaking apparatus 1, and at an end portion on the Y-axis positive side of the second conveyance rail 4.

After the scribe lines are formed, the film laminating unit 30 attaches a film 31 for protection on the surface WA of the wafer W, i.e., on a face where the scribe lines are formed. Here, although the specific configuration of the film laminating unit 30 is not described, the film laminating unit 30 includes, for example, the film 31 that is wound, an apparatus for sending out the film 31, a cutter for cutting the film 31, and the like.

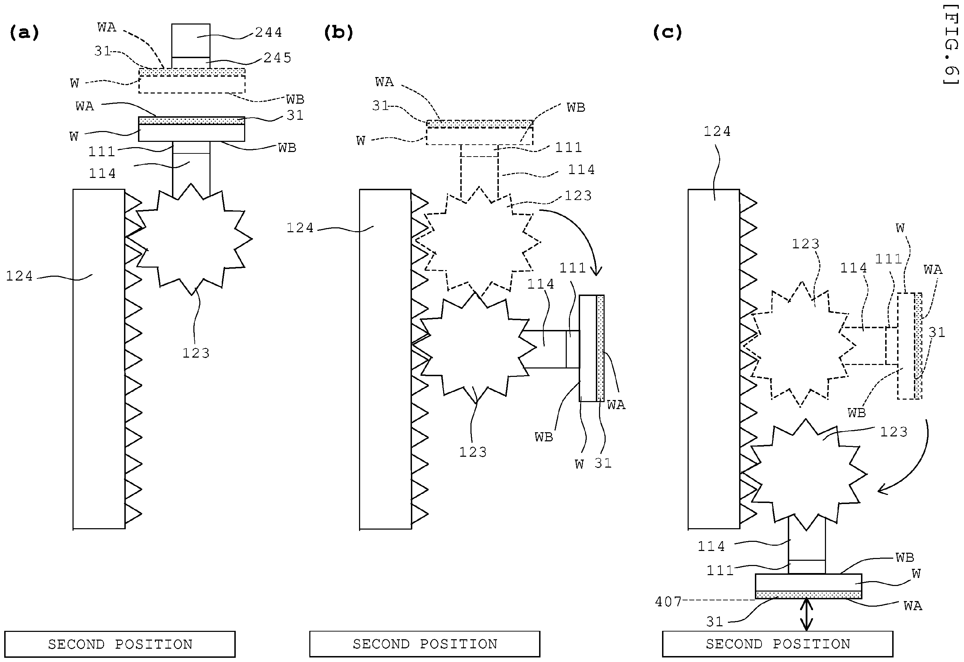

The film 31 can be configured to be peeled off during conveyance of the wafer W after the wafer W has been broken along the scribe lines. The film 31 is not shown in FIGS. 1 and 2, and is shown in FIGS. 6(a) to (c).

The break unit 40 breaks the wafer W along the scribe lines formed by the scribe unit 20. Similar to the scribe unit 20, as the break unit 40, a break unit that is usually used when breaking a brittle material substrate along scribe lines formed on the substrate such as a glass substrate, can be used.

In such a break unit 40, for example, a wafer W is placed on a break table 41 such that the surface WA of the wafer W is positioned on the lower side. That is, in the break unit 40, a back face WB of the wafer W is positioned on the upper side. In a state where the blade edge of a break bar (not shown) is positioned at one end of a scribe line and a predetermined pressure is applied to the wafer W, the break table 41 is moved along the Y axis at a predetermined interval. Accordingly, a crack is formed in the wafer W along the scribe line. When this crack is extended, the wafer W becomes able to be broken.

Similar to the formation of the scribe lines, cracks are formed along the plurality of scribe lines, and then, the break table 41 is rotated by 90° to form cracks in the wafer W. Accordingly, the wafer W is broken in a grid-like manner.

The break unit 40 is disposed on the X-axis positive side of the wafer breaking apparatus 1 and at an end portion on the Y-axis negative side of the second conveyance rail 4.

The inverting unit 100 is a unit for inverting the front and back faces of a wafer W. The inverting unit 100 inverts the front and back faces of a wafer W to which the film 31 has been attached by the film laminating unit 30, and of a wafer W that has been broken by the break unit 40.

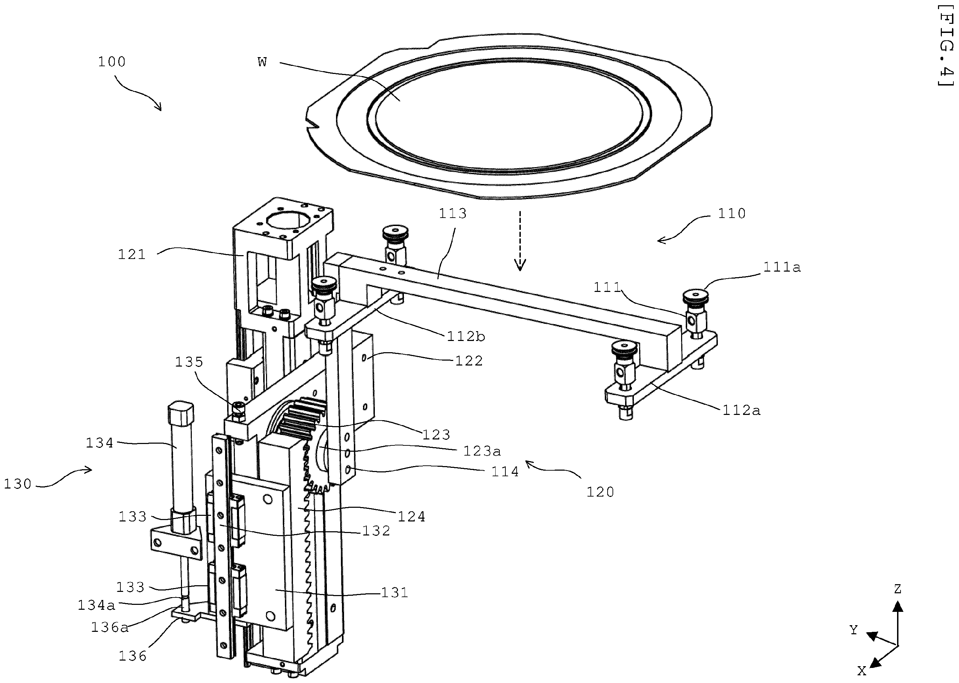

The configuration of the inverting unit 100 will be described later with reference to FIG. 4 to FIG. 8(b).

The conveyance part 200 conveys the wafer W in the wafer breaking apparatus 1. The conveyance part 200 includes a first conveyance portion 210, a second conveyance portion 220, a third conveyance portion 230, and a raising/lowering portion 240.

The first conveyance portion 210 conveys a wafer W taken out of the storage part 10, along the first conveyance rail 3 to a first position 401. The first conveyance portion 210 is also used when a wafer W having been broken by the break unit 40 is returned to the storage part 10. As shown in FIG. 1, the first position 401 is the region surrounded by a dashed line, and is provided at a position on the Y-axis positive side on the first conveyance rail 3.

The second conveyance portion 220 conveys a wafer W from the first position 401 to a second position 402 that is between the scribe unit 20 and the break unit 40. The "second position 402" corresponds to a "delivery position" described in the claims. As shown in FIG. 2, the second position 402 is a region surrounded by a dashed line, and is provided at a position opposed to the first position 401 on the second conveyance rail 4.

When a wafer W broken by the break unit 40 is returned to the storage part 10, the third conveyance portion 230 conveys the wafer W from the second position 402 to the first position 401.

In order to attach the film 31 to a wafer W on which scribe lines have been formed by the scribe unit 20, the raising/lowering portion 240 conveys the wafer W to a predetermined position in the film laminating unit 30. In addition, the raising/lowering portion 240 conveys a wafer W to which the film 31 has been attached to a predetermined position in the inverting unit 100. In the present embodiment, the "predetermined position in the film laminating unit 30" is a "third position 403", and the "predetermined position in the inverting unit 100" is a "fourth position 404".

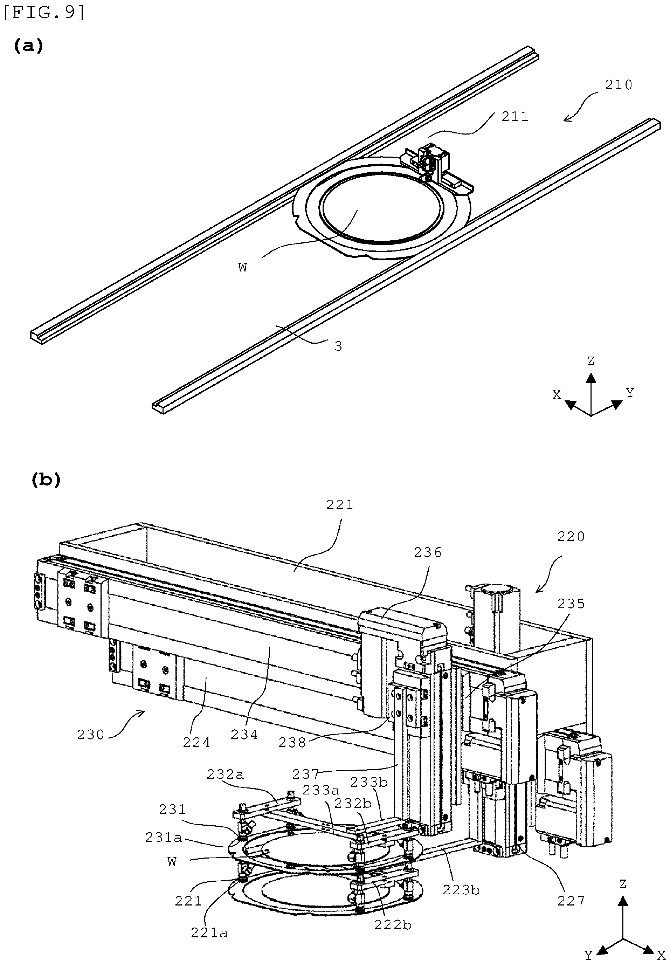

In addition, the wafer breaking apparatus 1 includes drive parts for driving these conveyance portions and the raising/lowering portion, and drive parts for moving the scribe table 21 and the break table 41 along the second conveyance rail 4. The conveyance part 200 and the drive parts will be described later with reference to FIG. 9(a) to FIG. 11.

### [Apparatus layout]

In the wafer breaking apparatus 1 according to the present embodiment, the installation area of the apparatus is suppressed and the operating rate per installation area is improved by devising the arrangement of the above-described units. The layout of the apparatus is described below.

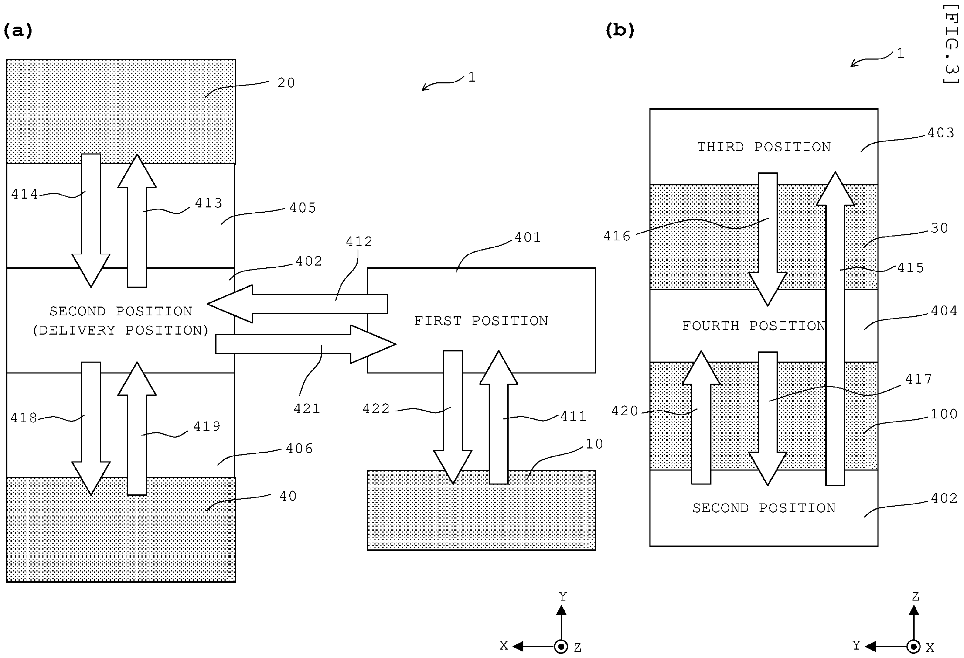

FIGS. 3(a) and 3(b) are each a schematic diagram for describing arrangement of the above-described units included in the wafer breaking apparatus 1 and conveyance of a wafer W. FIG. 3(a) schematically shows a view from the Z-axis positive side, i.e., shows arrangement of the units, the first position 401, and the second position 402 on an upper face 2a of the rack 2 shown in FIG. 1 and FIG. 2. FIG. 3(b) schematically shows a view from the X-axis positive side, i.e., shows arrangement of the units, the third position 403, and the fourth position 404 in the Z-axis direction with respect to the second position 402. In FIGS. 3(a) and 3(b), arrows 411 to 422 indicate conveyance directions of the wafer W.

First, arrangement of the units and the first position 401 to the fourth position 404 in the wafer breaking apparatus 1 is described.

In FIG. 3(a), and as described above, in the wafer breaking apparatus 1, the storage part 10 is disposed on the X-axis negative side, and the scribe unit 20 and the break unit 40 are disposed on the X-axis positive side. The second position 402, i.e., the delivery position, is provided between the scribe unit 20 and the break unit 40.

A stand-by position 405 is provided between the second position 402 and the scribe unit 20, and a stand-by position 406 is provided between the second position 402 and the break unit 40. As described above, when the scribe unit 20 forms scribe lines, the scribe table 21 reciprocates at a predetermined interval along the Y-axis direction. The stand-by positions 405 and 406 are each used as a stand-by place of a wafer W being conveyed. The stand-by positions 405 and 406 are respectively provided in order to secure movement ranges of the scribe table 21 and the break table 41.

As described above, the first position 401 and the second position 402 are provided at symmetric positions on the X-axis negative side and the X-axis positive side, respectively.

As shown in FIG. 3(b), the second position 402 is provided immediately below the inverting unit 100. The film laminating unit 30 is disposed above the inverting unit 100. The third position 403 is the position where a wafer W is positioned at the film laminating unit 30. Therefore, in FIG. 3(b), the third position 403 is shown on the upper side of the film laminating unit 30. Similar to this, the fourth position 404 is the position where a wafer W having been conveyed from the film laminating unit 30 is positioned at the inverting unit 100. That is, the fourth position 404 is a reception position described in the claims. Therefore, in FIG. 3(b), the fourth position 404 is shown on the upper side of the inverting unit 100.

Next, conveyance routes of a wafer W are described.

As indicated by the arrow 411 in FIG. 3(a), a wafer W is conveyed from the storage part 10 to the first position 401. At this time, the wafer W is conveyed by the first conveyance portion 210 along the first conveyance rail 3.

When the wafer W has arrived at the first position 401, as indicated by an arrow 412, the wafer W is conveyed from the first position 401 to the second position 402. At this time, the wafer W is conveyed by the second conveyance portion 220.

Next, as indicated by an arrow 413, the wafer W is conveyed from the second position 402 to the scribe unit 20. Then, when scribe lines have been formed by the scribe unit 20, the wafer W is conveyed to the second position 402 as indicated by an arrow 414. The scribe table 21 having the wafer W placed thereon is moved along the second conveyance rail 4, whereby the wafer W is conveyed between the second position 402 and the scribe unit 20.

While scribe lines are formed on the wafer W by the scribe unit 20, the wafer W reciprocates between the scribe unit 20 and the stand-by position 405. Meanwhile, for example, while scribe lines are formed on the wafer W, another wafer W may be positioned at the second position 402 in some cases. Therefore, until the second position 402 becomes vacant after the scribe lines have been formed on the wafer W, the wafer W stands by at the stand-by position 405.

Next, in order to attach the film 31 to the surface WA of the wafer W, the wafer W is conveyed to the film laminating unit 30. As indicated by an arrow 415 in FIG. 3(b), the wafer W is conveyed from the second position 402 to the third position 403. At this time, the wafer W is conveyed by the raising/lowering portion 240.

When the film 31 has been attached to the surface WA of the wafer W by the film laminating unit 30, the wafer W is conveyed from the film laminating unit 30 to the fourth position 404 as indicated by an arrow 416. At this time, the wafer W is conveyed by the raising/lowering portion 240. The wafer W having been conveyed to the fourth position 404 is then positioned to the second position 402 while being inverted by the inverting unit 100 such that the front and back faces of the wafer W are reversed. That is, as indicated by an arrow 417, the inverting unit 100 conveys the wafer W to the second position 402. Accordingly, the surface WA of the wafer W, i.e., the face to which the film 31 has been attached, is positioned on the lower side. The configuration of the inverting unit 100 will be described later in detail.

Next, as indicated by an arrow 418 in FIG. 3(a), the wafer W is conveyed from the second position 402 to the break unit 40. Then, when the wafer W has been broken along the scribe lines by the break unit 40, the wafer W is conveyed to the second position 402 as indicated by an arrow 419. The break table 41 having the wafer W placed thereon is moved along the second conveyance rail 4, whereby the wafer W is conveyed between the second position 402 and the break unit 40.

While the wafer W is broken by the break unit 40, the wafer W reciprocates between the break unit 40 and the stand-by position 406. Meanwhile, for example, while the wafer W is broken, another wafer W may be positioned at the second position 402 in some cases. Therefore, until the second position 402 becomes vacant after the wafer W has been broken, the wafer W stands by at the stand-by position 406.

As indicated by an arrow 420 in FIG. 3(b), the wafer W is conveyed from the second position 402 to the fourth position 404. At this time, the wafer W is conveyed by the raising/lowering portion 240. The wafer W having been conveyed to the fourth position 404 is then positioned to the second position 402 while being inverted by the inverting unit 100 such that the front and back faces of the waver W are reversed. That is, as indicated by the arrow 417 the inverting unit 100 conveys the wafer W to the second position 402. Accordingly, the surface WA of the wafer W, i.e., the face to which the film 31 has been attached, is positioned on the upper side.

As indicted by an arrow 421 in FIG. 3(a), the wafer W is conveyed from the second position 402 to the first position 401. At this time, the wafer W is conveyed by the third conveyance portion 230. Then, as indicated by the arrow 422, the wafer W is conveyed from the first position 401 to the storage part 10, to be stored in the storage part 10. At this time, the wafer W is conveyed by the first conveyance portion 210 along the first conveyance rail 3. In this manner, the wafer W is conveyed in the wafer breaking apparatus 1.

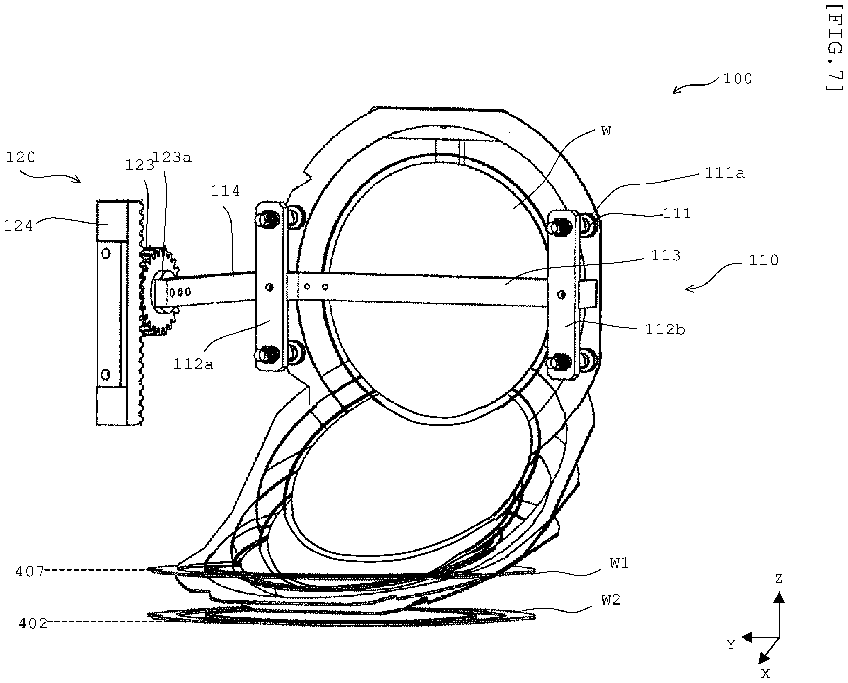

In the conveyance of the wafer W as described above, while inverting the wafer W delivered at an upper position (the fourth position 404), the inverting unit 100 places the wafer W to a lower position (the second position 402). That is, the inverting unit 100 performs inversion and conveyance at the same time. Such a configuration of the inverting unit 100 is described with reference to FIG. 4 to FIG. 8(b). FIG. 6(c) and FIG. 7 each show an inversion completion position 407 which is the position where inversion of the wafer W is completed.

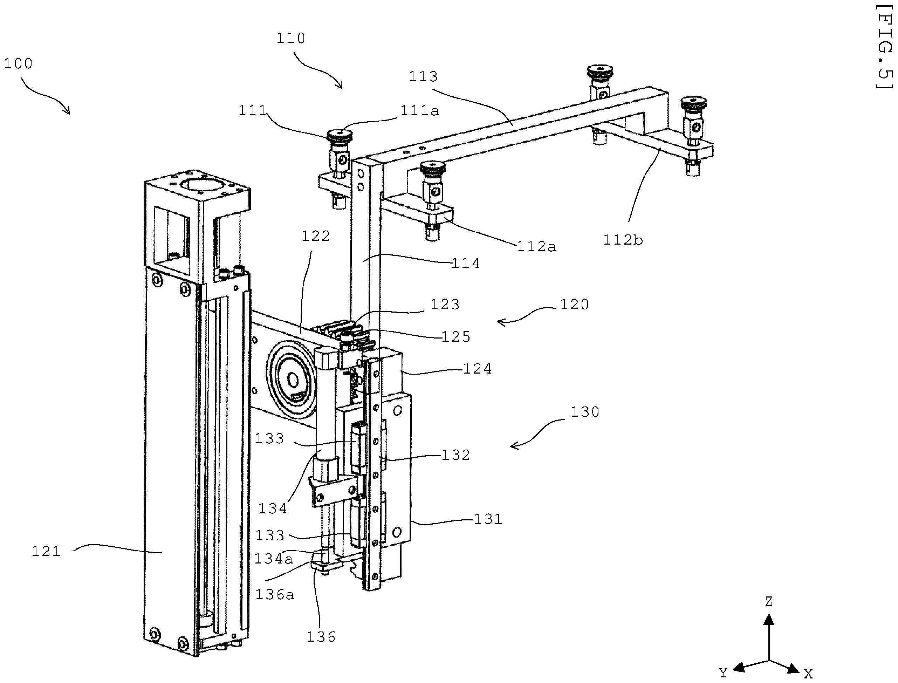

FIG. 4 and FIG. 5 are each a perspective view showing a configuration of the inverting unit 100. FIG. 4 and FIG. 5 each show a state immediately before a wafer W is held by the inverting unit 100, for example, a case where a wafer W having been conveyed from the film laminating unit 30 is to be received or a case where a wafer W having been conveyed through the break unit 40 is to be received.

As shown in FIG. 4, the inverting unit 100 includes a holding part 110, a rotation drive part 120, and an adjustment mechanism 130.

The holding part 110 holds a wafer W by suction. The holding part 110 includes four suction portions 111 for suctioning the wafer W, plates 112a, 112b, a holding member 113, and a lever 114. As for the four suction portions 111, two suction portions 111 are provided to each of the plates 112a and 112b. The plates 112a and 112b are coupled to both end portions of the holding member 113, respectively. One end portion of the lever 114 is connected to the holding member 113, and the other end portion of the lever 114 is mounted to a rotation shaft 123a.

The four suction portions 111 are each a suction pad. As indicated by a dashed line arrow in FIG. 4, a wafer W is placed on suction faces 111a of the four suction portions 111. When the wafer W is placed on the suction faces 111a of the suction portions 111, a negative pressure is applied to the suction portions 111. Accordingly, the wafer W is suctioned and held by the suction portions 111.

The rotation drive part 120 moves the holding part 110 in a linear direction (the Z-axis direction) while rotating the holding part 110. The rotation drive part 120 includes a drive mechanism 121, a support member 122, a pinion gear 123, and a rack gear 124.

The drive mechanism 121 raises/lowers the support member 122 between the fourth position 404 (see FIGS. 6(a) to 6(c)) serving as the reception position where the holding part 110 receives the wafer W and the inversion completion position 407 (FIGS. 6(a) to 6(c)) where inversion of the wafer W is completed, i.e., where the holding part 110 is positioned after having been rotated by 180° from the fourth position 404. The drive mechanism 121 includes a guide that guides the support member 122 in the Z-axis direction, a motor as a driving source, and a transmission mechanism (not shown) that transmits the driving force of the motor to the support member 122.

The support member 122 is a rectangular plate member and is provided with a hole on the X-axis positive side thereof. The pinion gear 123 is fitted in this hole. The pinion gear 123 is rotatably mounted to the support member 122. The lever 114 is mounted to the rotation shaft 123a of the pinion gear 123. The rack gear 124 is a member meshed with the pinion gear 123 and extending in a linear direction.

The adjustment mechanism 130 includes a moving member 131, a guide 132, two sliders 133, a biasing member 134, a contacting part 135, and a contacted part 136. The adjustment mechanism 130 adjusts movement of the rack gear 124.

The rack gear 124 is coupled to the face on the X-axis negative side of the moving member 131. The moving member 131 is coupled to the guide 132 so as to be movable in a sliding manner, via the two sliders 133 mounted to the face on the X-axis positive side of the moving member 131. The guide 132 is fixed to a chassis (not shown).

The biasing member 134 is a member that biases the moving member 131 in the Z-axis positive direction. The biasing member 134 is, for example, an air cylinder or an air spring. In the present embodiment, the biasing member 134 is an air cylinder. Hereinafter, in the present embodiment, the "biasing member 134" is expressed as an "air cylinder 134".

The contacted part 136 is a flange portion provided to the moving member 131. The contacted part 136 is provided with a hole 136a for mounting a lower end portion 134a of the air cylinder 134. The support member 122 is provided with a protrusion 125 at an upper end portion on the X-axis negative side of the support member 122. The protrusion 125 is provided with a hole in the Z-axis direction, and the contacting part 135 is mounted in this hole. The contacting part 135 is not limited in particular as long as the contacting part 135 can come into contact with the contacted part 136. In the present embodiment, the contacting part 135 is a bolt. Hereinafter, in the present embodiment, the "contacting part 135" is expressed as a "bolt 135", and the "contacted part 136" is expressed as a "flange portion 136".

Until the holding part 110 is positioned at the inversion completion position 407, the air cylinder 134 is maintained to have a predetermined pressure so as to be in a most contracted state. Accordingly, the air cylinder 134 fixes the moving member 131 at a raised position (the Z-axis positive direction). Therefore, during this time, linear movement along the guide 132 of the moving member 131 does not occur. The pressure of the air cylinder 134 at this time is about 0.5 MPa.

In contrast, when the holding part 110 has been moved to the inversion completion position 407, the bolt 135 comes into contact with the flange portion 136. Then, when the support member 122 is further moved downwardly (the Z-axis negative direction), the flange portion 136 is pressed by the bolt 135, and the moving member 131 receives a pressing force from the support member 122. At this time, the pressure being applied to the air cylinder 134 is reduced. For example, the pressure of the air cylinder 134 is reduced to about 0.1 MPa. That the holding part 110 has reached the inversion completion position 407 is detected by a sensor (not shown), for example. In this manner, the pressing force by the support member 122 acts more on the moving member 131 than the biasing force by the air cylinder 134 does. Accordingly, in association with movement of the support member 122, the moving member 131 is further moved by a predetermined number of strokes from the inversion completion position 407, against the biasing applied by the air cylinder 134.

When the support member 122 is moved by the predetermined number of strokes from the inversion completion position 407, the rack gear 124 is moved together with the moving member 131. Thus, no relative movement is caused between the rack gear 124 and the pinion gear 123. Therefore, further rotation of the holding part 110 does not occur during the movement of the support member 122. Accordingly, the wafer W is smoothly delivered from the inversion completion position 407 to the second position 402.

FIGS. 6(a) to 6(c) are each a schematic diagram showing inversion operation of a wafer W performed by the inverting unit 100. In FIGS. 6(a) to 6(c), only the wafer W, the suction portion 111, the lever 114, the pinion gear 123, and the rack gear 124 are shown.

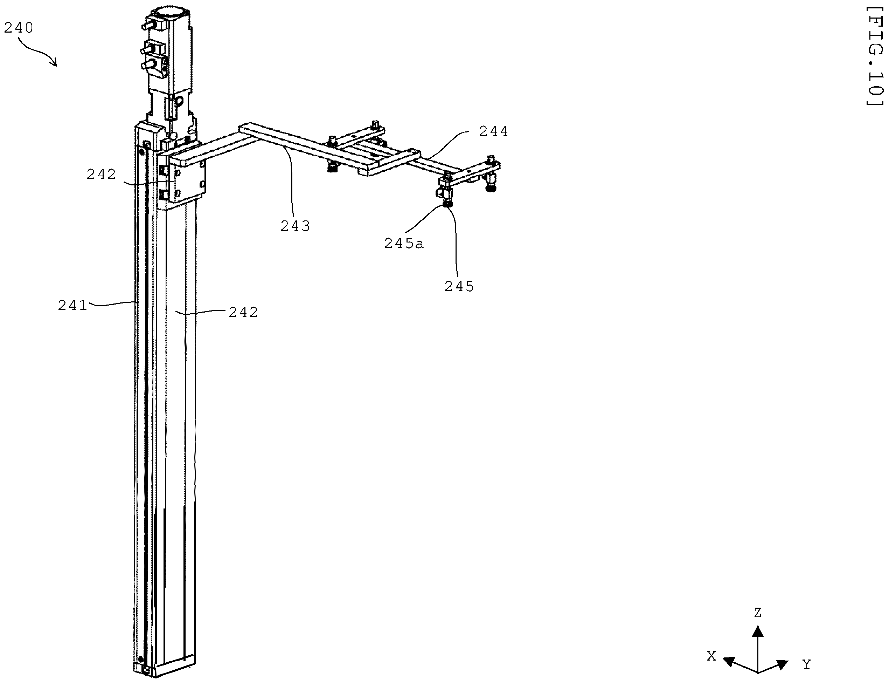

FIG. 6(a) shows a case where the inverting unit 100 receives a wafer W at the fourth position 404. In FIG. 6(a), the inverting unit 100 receives the wafer W through the raising/lowering portion 240. In this case, in the inverting unit 100, the pinion gear 123 is positioned in an upper portion of the rack gear 124, the lever 114 extends in the Z-axis direction, and the suction face 111a of the suction portion 111 stands by in a state of facing upward. The wafer W is placed on the suction face 111a of the suction portion 111 and held by suction, in a state where the surface WA of the wafer W is positioned on the upper side and the back face WB of the wafer W positioned on the lower side. That is, of the faces of the wafer W, the face that comes into contact with the suction face 111a is the back face WB. The raising/lowering portion 240 is shown in FIG. 10.

When the support member 122 described above is linearly moved in the Z-axis negative direction by the drive mechanism 121, the pinion gear 123 is rotated on the rack gear 124. Accordingly, the rotation shaft 123a is rotated and the lever 114 is rotated. FIG. 6(b) shows a case where the rotation shaft 123a has been rotated by 90° from the state shown in FIG. 6(a) to the Y-axis negative side. When the support member 122 further linearly moves the drive mechanism 121 in the Z-axis negative direction from the state shown in FIG. 6(b), the pinion gear 123 is rotated on the rack gear 124. As a result of the rotation of the pinion gear 123, the rotation shaft 123a is rotated, and the lever 114 is rotated. From the state shown in FIG. 6(b), rotation is further made by 90° to the Y-axis negative side. That is, when the holding part 110 has been rotated by 180° from the fourth position 404, the holding part 110 is positioned at the inversion completion position 407, and as shown in FIG. 6(c), the wafer W is inverted such that the front and back faces thereof are reversed, and the back face WB is positioned on the upper side.

FIG. 7 is an image diagram showing how the state of the wafer W is transitioned from the state shown in FIG. 6(b) to the state shown in FIG. 6(c). In FIG. 7, two wafers W in a state of being parallel to the X-Y plane are shown. Of these wafers W, the wafer W on the Z-axis positive side is the wafer W positioned at the inversion completion position 407, and is expressed as a wafer W1 for convenience of description. The wafer W on the Z-axis negative side is the wafer W positioned at the second position 402, and is expressed as a wafer W2 for convenience of description. The wafer W1 (the inversion completion position 407) and the wafer W2 (the second position 402) are separated from each other.

In general, a brittle substrate such as a semiconductor wafer or a glass material is a thin film and is weak to impact. Therefore, when a wafer W comes into contact with a member at the second position 402 during inversion operation, the wafer W could be damaged by the impact.

Thus, in order to assuredly prevent the above-mentioned damage of the wafer W, the inversion completion position 407 is separated from the second position 402 in the inverting unit 100. Accordingly, during inversion operation of the wafer W, the wafer W is prevented from coming into contact with a member at the second position 402.

Next, a configuration of the inverting unit 100 for allowing a wafer W positioned at the inversion completion position 407 to be moved to the second position 402 is described.

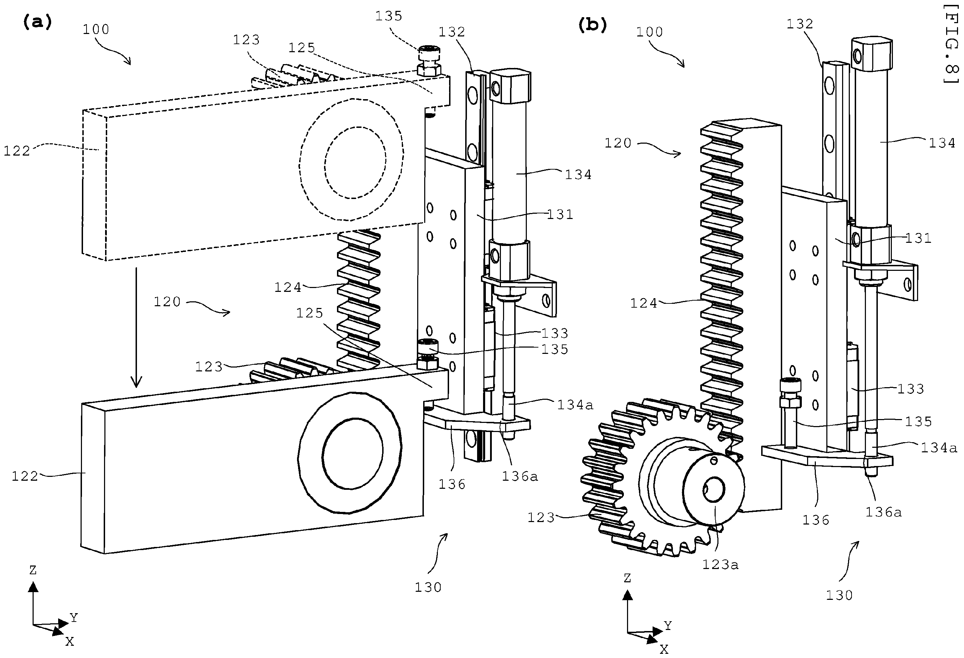

FIGS. 8(a) and 8(b) are each a perspective view for describing a configuration of the inverting unit 100. For convenience of description, in FIGS. 8(a) and 8(b), the drive mechanism 121, the holding member 113, the lever 114, and the wafer W are not shown. In FIG. 8(b), the support member 122 is also not shown.

The dashed lines in FIG. 8(a) indicate the states of the pinion gear 123 and the support member 122 when a wafer W is positioned at the fourth position 404. This state corresponds to the state shown in FIGS. 4, 5, and FIG. 6(a). From the state indicated by the dashed lines in FIG. 8(a), the support member 122 is linearly moved by the drive mechanism 121 to the Z-axis negative side. That is, the holding part 110 is rotated while being moved from the fourth position 404 toward the inversion completion position 407. At this time, a predetermined pressure is being applied to the air cylinder 134, and the air cylinder 134 is biasing the moving member 131 in a direction from the inversion completion position 407 toward the fourth position 404.

As indicated by a solid line in FIG. 8(a), the support member 122 is linearly moved, and the bolt 135 provided to the support member 122 comes into contact with the flange portion 136. At this time, the holding part 110 is positioned at the inversion completion position 407, which corresponds to the state shown in FIG. 6(c). The wafer W at this time is the wafer W1 shown in FIG. 7. When the bolt 135 comes into contact with the flange portion 136 and the support member 122 presses the moving member 131, the predetermined pressure applied to the air cylinder 134 is reduced. Accordingly, the pressing force on the moving member 131 by the support member 122 exceeds the biasing force by the air cylinder 134. This allows the moving member 131 to move along the guide 132 in a sliding manner against the biasing force by the air cylinder 134.

Since the moving member 131 has the rack gear 124 coupled thereto, the support member 122, the pinion gear 123, the rack gear 124, and the moving member 131 are integrally moved from the inversion completion position 407 to the second position 402. Thus, no relative movement is caused between the pinion gear 123 and the rack gear 124, and therefore, further rotation of the wafer W does not occur during the movement from the inversion completion position 407 to the second position 402. Accordingly, the wafer W can be smoothly moved from the inversion completion position 407 to the second position 402. The wafer W at this time corresponds to the wafer W2 shown in FIG. 7.

As described above, as shown in FIG. 6(c), when the holding part 110 is rotated by 180° from the fourth position 404 and the holding part 110 is positioned at the inversion completion position 407, the bolt 135 comes into contact with the flange portion 136, and the support member 122 presses the moving member 131. In this case, the length of the bolt 135, i.e., the length protruding downwardly from the protrusion 125 of the support member 122, is appropriately adjusted such that the support member 122 is moved from the inversion completion position 407 together with the moving member 131.

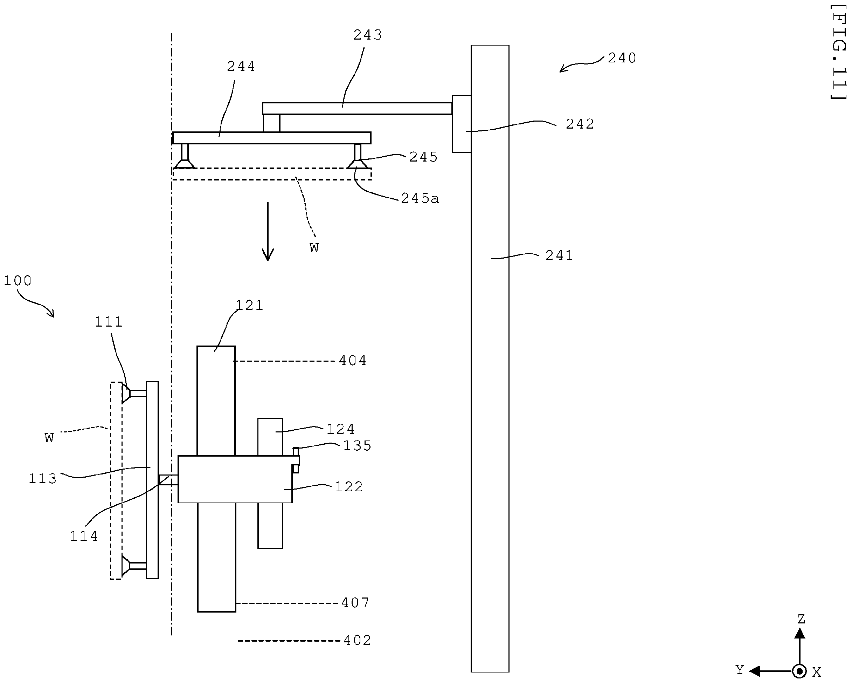

Arrangement of the inverting unit 100 and the raising/lowering portion 240 when a wafer W is delivered to the inverting unit 100 will be described later with reference to FIG. 11.

Next, the conveyance part 200 is described. FIG. 9(a) is a perspective view showing a configuration of the first conveyance portion 210, and FIG. 9(b) is a perspective view showing configurations of the second conveyance portion 220 and the third conveyance portion 230.

As shown in FIG. 9(a), the first conveyance portion 210 holds a wafer W, which is gripped by a gripping portion 211 configured to grip a wafer W. The first conveyance portion 210 grips the wafer W by means of the gripping portion 211, and conveys the wafer W along the first conveyance rail 3.

As shown in FIG. 9(b), the second conveyance portion 220 and the third conveyance portion 230 are installed on a common base 250.

Two suction portions 231 are provided to each of two plates 232a and 232b as the four suction portions 231 of the third conveyance portion 230. The two plates 232a, 232b are respectively mounted to both end portions of a shaft 233a in the X-axis direction of an arm 233. A shaft 233b in the Y-axis direction of the arm 233 is connected to a raising/lowering rail 237.

A conveyance rail 234 of the third conveyance portion 230 is a rail for conveying a wafer W in the X-axis direction. A slider 235 movable in a sliding manner is mounted to the conveyance rail 234, and a movable body 236 is set to the slider 235. The movable body 236 is mounted to a slider 238 so as to be able to be raised/lowered. The slider 238 is mounted to the raising/lowering rail 237.

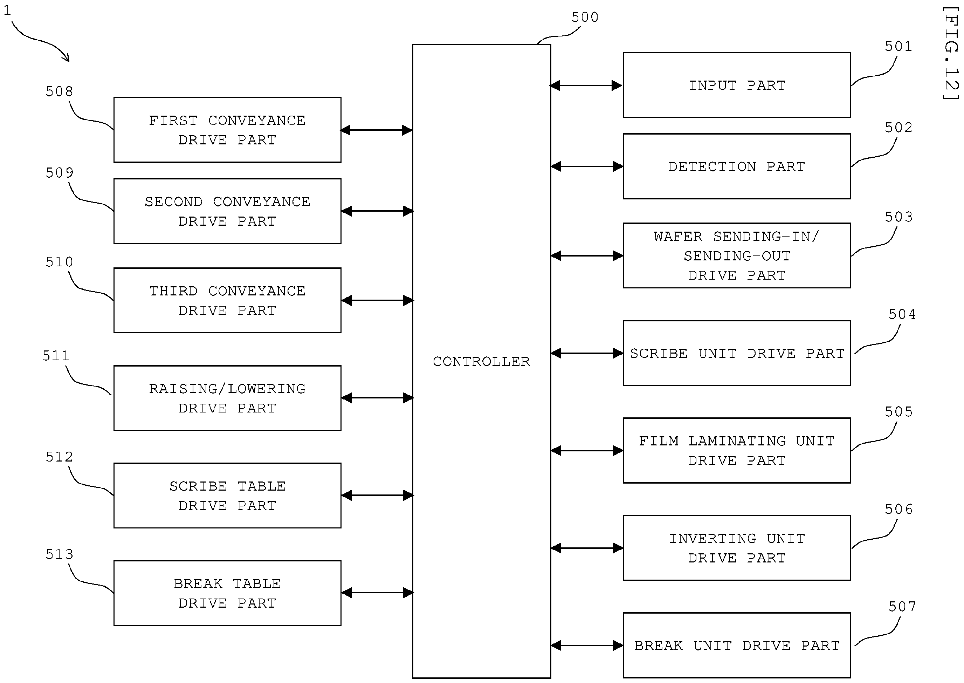

When a wafer W comes into contact with suction faces 231a of the suction portions 231, the third conveyance portion 230 having the above-described configuration suctions and holds the wafer W. In the third conveyance portion 230, when the wafer W is moved in the X-axis direction, the slider 235 is moved along the conveyance rail 234 by a third conveyance drive part 510. When the wafer W is moved in the Z-axis direction, the slider 238 is raised/lowered along the raising/lowering rail 237 by the third conveyance drive part 510. The third conveyance drive part 510 is shown in FIG. 12.

The second conveyance portion 220 also has a configuration similar to that of the third conveyance portion 230. In FIG. 9(b), only suction portions 221, suction faces 221a, a plate 222b, the shaft 233b in the Y-axis direction of the arm 233, a conveyance rail 224, and a raising/lowering rail 227 are shown in the drawing, and the other members are omitted.

Similar to the third conveyance portion 230, during conveyance of a wafer W, when a wafer W comes into contact with the suction faces 221a of the suction portions 221, the second conveyance portion 220 suctions and holds the wafer W. When the wafer W is moved in the X-axis direction, the slider is moved along the conveyance rail 224 by a second conveyance drive part 509. When the wafer W is moved in the Z-axis direction, the slider is raised/lowered along the raising/lowering rail 227 by the second conveyance drive part 509. The second conveyance drive part 509 is shown in FIG. 12.

FIG. 10 is a perspective view showing a configuration of the raising/lowering portion 240. The raising/lowering portion 240 includes: a conveyance member 242 that is moved along a raising/lowering guide 241 so as to be able to be raised/lowered in the Z-axis direction; an arm 243 coupled to the conveyance member 242; a holding member 244 coupled to the arm 243; and suction portions 245 held by the holding member 244. The raising/lowering portion 240 includes a drive portion that drives the conveyance member 242, and a pressure application portion that applies a pressure to the suction portions 245. The drive portion and the pressure application portion are not shown. The suction portions 245 of the raising/lowering portion 240 are each a suction pad, and a wafer W comes into contact with suction faces 245a of the suction portions 245.

When the holding part 110 of the inverting unit 100 is in a state shown in FIG. 6(a), i.e., when the holding part 110 is positioned at the fourth position 404, the conveyance member 242 is moved along the raising/lowering guide 241 to deliver the wafer W to the suction portions 111 of the inverting unit 100.

When the holding part 110 is moved from the fourth position 404 to be at a position of 90° to the Y-axis negative side, a space is generated between the fourth position 404 and the inversion completion position 407. Thus, as shown in FIG. 11, when the length of the lever 114 is adjusted, the conveyance member 242 can move the holding member 244 so as to be raised/lowered such that the suction portions 245 do not interfere with the wafer W held by the inverting unit 100. In this case, as indicated by a chain line in FIG. 11, the length of the lever 114 is set such that the suction portion 245 on the Y-axis positive side of the raising/lowering portion 240 does not come into contact with the holding member 113 of the inverting unit 100. The arrangement of the inverting unit 100 and the raising/lowering portion 240 is adjusted in accordance with the length of the lever 114.

When the raising/lowering portion 240 is configured as described above, the wafer W placed at the second position 402 can be sent out by the raising/lowering portion 240. That is, the lever 114 of the inverting unit 100 rotates the holding part 110 so as to be rotated by 90° from the fourth position 404 to the X-axis negative side, and while the holding part 110 is caused to stand by at that position, the conveyance member 242 of the raising/lowering portion 240 is lowered to the second position 402, and the wafer W is suctioned by the suction portions 245. Then, when the conveyance member 242 is raised from the second position 402 toward the fourth position 404, the wafer W can be positioned at the fourth position 404.

When the length of the lever 114 is large, the wafer W is rotated in a large arc shape in accordance with a radius based on the lever 114. Thus, when the holding part 110 is at a position to which the holding part 110 has been rotated by 90° from the fourth position 404 to the Y-axis negative side, the wafer W and the suction portions 245 do not come into contact with each other. However, when the length of the lever 114 is excessively large, it is necessary to secure a space in the horizontal direction and the height direction so as to allow rotation of the holding part 110. This results in an increased size of the apparatus. Therefore, the length of the lever 114 is adjusted in consideration of the diameter of the wafer W, the length of the holding member 244 of the raising/lowering portion 240, the positional relationship between the inverting unit 100 and the raising/lowering portion 240, and the like.

As shown in FIG. 10, the arm 243 of the raising/lowering portion 240 is composed of a plurality of plate members. The arm 243 composed of these plate members is allowed to have an unstable shape such that the arm 243 can pass between the fourth position 404 and the second position 402 without interfering with the holding part 110 of the inverting unit 100 and the like.

When the raising/lowering portion 240 conveys the wafer W from the second position 402 to the third position 403, the conveyance member 242 is lowered along the raising/lowering guide 241, whereby the arm 243, the holding member 244, and the suction portions 245 are lowered and the wafer W comes into contact with the suction faces 245a of the suction portions 245. When the wafer W has been suctioned by the suction portions 245, the conveyance member 242 is raised along the raising/lowering guide 241, whereby the wafer W is conveyed to the film laminating unit 30, i.e., the third position 403. This state corresponds to FIG. 6(a).

When the film 31 is attached to the surface WA of the wafer W by the film laminating unit 30, the suction portions 245 suction the surface WA of the wafer W, and the conveyance member 242 is lowered along the raising/lowering guide 241, whereby the wafer W is conveyed to the inverting unit 100, i.e., the fourth position 404, which is the reception position.

In this manner, the raising/lowering portion 240 conveys the wafer W to the film laminating unit 30 and the inverting unit 100 by raising/lowering the conveyance member 242.

### [Operation of wafer breaking apparatus]

Next, operation of the wafer breaking apparatus 1 is described. FIG. 12 is a block diagram showing a configuration of the wafer breaking apparatus 1. The wafer breaking apparatus 1 includes the storage part 10, the scribe unit 20, the film laminating unit 30, the break unit 40, the inverting unit 100, the first conveyance portion 210, the second conveyance portion 220, the third conveyance portion 230, and the raising/lowering portion 240, and further includes a controller 500, an input part 501, a detection part 502, a wafer sending-in/sending-out drive part 503, a scribe unit drive part 504, a film laminating unit drive part 505, an inverting unit drive part 506, and a break unit drive part 507, as shown in FIG. 12. Furthermore, the wafer breaking apparatus 1 includes a first conveyance drive part 508, the second conveyance drive part 509, the third conveyance drive part 510, and a raising/lowering drive part 511, which are respective drive parts for the first conveyance portion 210, the second conveyance portion 220, the third conveyance portion 230, and the raising/lowering portion 240. Further, the wafer breaking apparatus 1 includes a scribe table drive part 512 and a break table drive part 513.

The input part 501 receives start of braking of a wafer W performed by the wafer breaking apparatus 1. The detection part 502 detects that the wafer W is positioned at each unit in the wafer breaking apparatus 1. The detection part 502 may be configured to detect the position of the wafer W being conveyed. As the detection part 502, a sensor, an imaging apparatus, or the like can be used, for example.

The controller 500 includes an arithmetic processing circuit such as a CPU, and a memory such a ROM, a RAM, a hard disk, or the like. The controller controls components in accordance with programs stored in the memory.

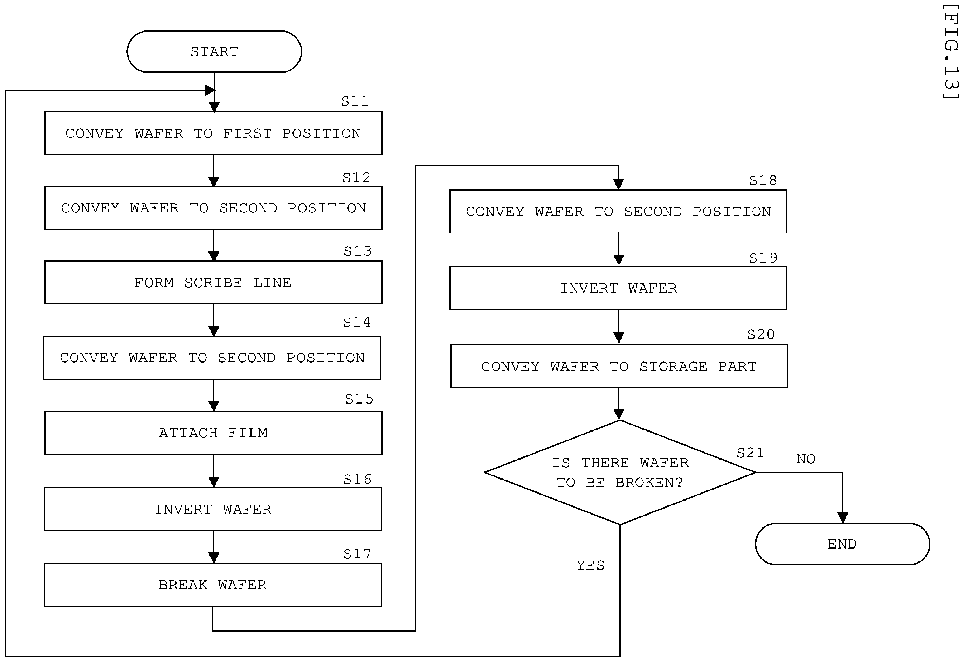

FIG. 13 is a flow chart showing operation of the wafer breaking apparatus 1 according to the present embodiment. This control is executed by the controller 500 shown in FIG. 12. In the flow chart shown in FIG. 13, "START" is the time point at which start of breaking of a wafer W is received by the input part. A plurality of wafers W are stored in advance in the storage part 10.

In step S11, the controller 500 causes the wafer sending-in/sending-out drive part 503 to open the door of the storage part 10, to cause a wafer W to be sent into the wafer breaking apparatus 1. Then, the controller 500 causes the first conveyance drive part 508 to drive the first conveyance portion 210, to cause the wafer W to be conveyed to the first position 401. This corresponds to the conveyance route indicated by the arrow 411 in FIG. 3(a).

In step S12, when the detection part 502 has detected that the wafer W has arrived at the first position 401, the controller 500 causes the second conveyance drive part 509 to drive the second conveyance portion 220, to cause the wafer W having arrived at the first position 401, to be conveyed to the second position 402, i.e., the delivery position. The second conveyance drive part 509 operates the arm of the second conveyance portion 220 such that the suction faces 221a of the suction portions 221 come into contact with the surface WA of the wafer W. When the suction faces 221a of the suction portions 221 have come into contact with the surface WA of the wafer W, the second conveyance drive part 509 applies a negative pressure to the suction portions 221 so as to cause the wafer W to be suctioned by the suction portions 221. Accordingly, the wafer W is held by the second conveyance portion 220. Then, the second conveyance drive part 509 drives the second conveyance portion 220 to convey the wafer W to the second position 402. This corresponds to the conveyance route indicated by the arrow 412 in FIG. 3(a).

In addition, in step S12, while the second conveyance portion 220 is caused to convey the wafer W until the wafer W arrives at the second position 402, the controller 500 drives the scribe table drive part 512 to move the scribe table 21 to the second position 402.

When the detection part 502 has detected that the wafer W has arrived at the scribe table 21 having been moved to the second position 402, the controller 500 causes the second conveyance drive part 509 to apply a positive pressure to the suction portions 221 of the second conveyance portion 220. Accordingly, suction of the wafer W by the suction portions 221 is canceled, and the wafer W is detached from the suction portions 221. Then, the controller 500 drives the scribe table drive part 512 to apply a negative pressure to the scribe table 21. Accordingly, the wafer W is suctioned by the upper face of the scribe table 21 and is placed thereon.

In step S13, the controller 500 drives the scribe table drive part 512 to move the scribe table 21 from the second position 402 to the scribe unit 20. This corresponds to the conveyance route indicated by the arrow 413 in FIG. 3(a). When the detection part 502 has detected that the scribe table 21 has arrived at a predetermined position in the scribe unit 20, the controller 500 causes the scribe unit drive part 504 to drive the scribe unit 20, to form scribe lines on the surface WA of the wafer W.

After step S13, the controller 500 drives the scribe table drive part 512 to move the scribe table 21 to the second position 402. Accordingly, the wafer W is conveyed to the second position 402 (S14). This corresponds to the conveyance route indicated by the arrow 414 in FIG. 3(a).

In step S15, when the detection part 502 has detected that the wafer W has arrived at the second position 402, the controller 500 drives the scribe table drive part 512 to apply a positive pressure to the wafer W. This allows the wafer W to be separated from the upper face of the scribe table 21.

Then, the controller 500 causes the raising/lowering drive part 511 to drive the raising/lowering portion 240, to operate the arm 243 of the raising/lowering portion 240 such that the suction faces 245a of the suction portions 245 come into contact with the surface WA of the wafer W. When the suction faces 245a of the suction portions 245 have come into contact with the surface WA of the wafer W, the raising/lowering drive part 511 applies a negative pressure to the suction portions 245 to cause the wafer W to be suctioned by the suction portions 245. Accordingly, the wafer W is held by the raising/lowering portion 240. Then, the raising/lowering drive part 511 drives the raising/lowering portion 240 to be conveyed to a predetermined position in the film laminating unit 30, i.e., the third position 403. This corresponds to the conveyance route indicated by the arrow 415 in FIG. 3(b).

As described above, the holding part 110 of the inverting unit 100 stands by at the fourth position 404 in FIG. 3(b), i.e., the reception position, such that the arm 243, the holding member 244, and the suction portions 245 of the raising/lowering portion 240 and the holding part 110 of the inverting unit 100 do not collide with each other.

When the detection part 502 has detected that the wafer W has arrived at the third position 403, the controller 500 causes the film laminating unit drive part 505 to drive the film laminating unit 30, to attach the film 31 to the surface WA of the wafer W.

In step S16, the wafer W is conveyed by the raising/lowering portion 240 from the third position 403 to the fourth position. Then, the wafer W is conveyed while being inverted, from the fourth position 404 to the second position.

In step S16, while the wafer W is inverted, the controller 500 drives the break table drive part 513 to move the break table 41 to the second position 402. Thus, the wafer W having been conveyed from the fourth position 404 to the second position 402 while being inverted by the inverting unit 100 is placed on the break table 41.

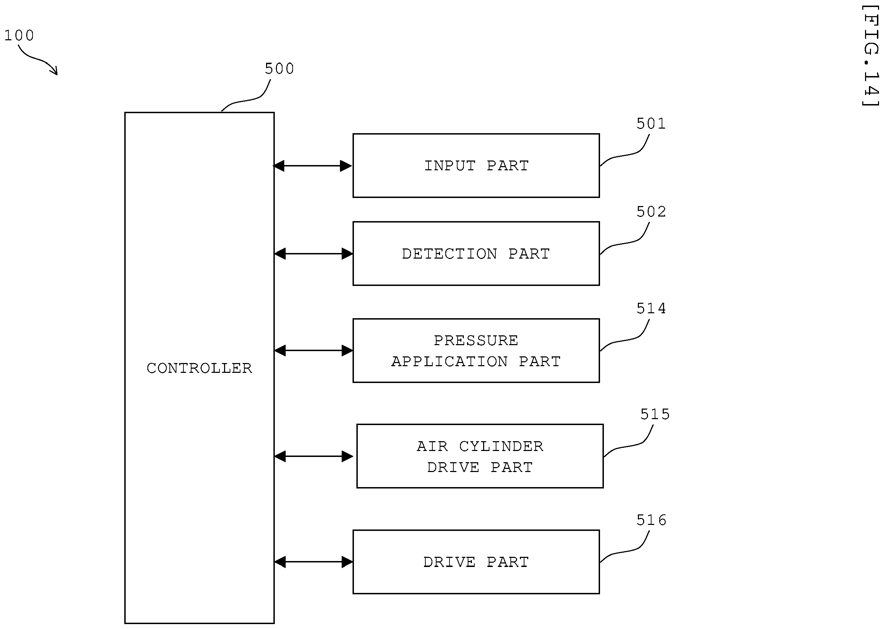

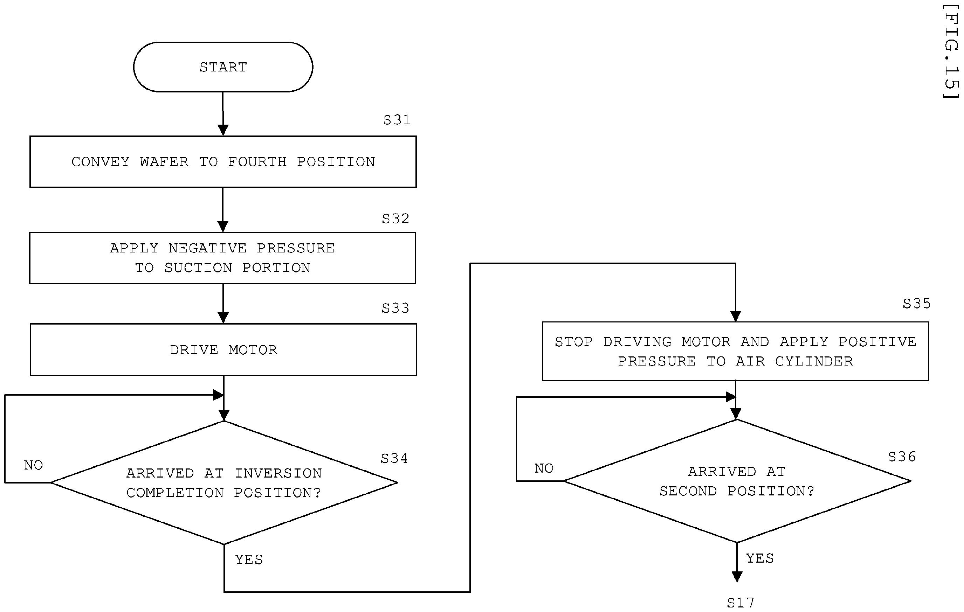

This operation of the inverting unit 100 will be described later with reference to FIG. 14 and FIG. 15.

In step S17, the controller 500 drives the break table drive part 513 to move the break table 41 from the second position 402 to the break unit 40. This corresponds to the conveyance route indicated by the arrow 418 in FIG. 3(a). When the detection part 502 has detected that the break table 41 has arrived at a predetermined position in the break unit 40, the controller 500 causes the break unit drive part 507 to drive the break unit 40 to break the wafer W along the scribe lines.

After step S17, the controller 500 drives the break unit drive part 507 to move the break table 41 to the second position 402. Accordingly, the wafer W is conveyed to the second position 402. This corresponds to the conveyance route indicated by the arrow 419 in FIG. 3(a).

In step S19, when the detection part 502 has detected that the wafer W has arrived at the second position 402, the controller 500 drives the break table drive part 513 to apply a positive pressure to the wafer W. This allows the wafer W to be separated from the upper face of the break table 41.

Then, the controller 500 causes the raising/lowering drive part 511 to drive the raising/lowering portion 240, to operate the raising/lowering portion 240 such that the suction faces 245a of the suction portions 245 come into contact with the back face WB of the wafer W. When the suction faces 245a of the suction portions 245 have come into contact with the back face WB of the wafer W, the raising/lowering drive part 511 applies a negative pressure to the suction portions 245 to cause the wafer W to be suctioned by the suction portions 245. Accordingly, the wafer W is held by the raising/lowering portion 240. Then, the raising/lowering drive part 511 drives the raising/lowering portion 240 to be conveyed to a predetermined position in the inverting unit 100, i.e., the fourth position 404. This corresponds to the conveyance route indicated by the arrow 420 in FIG. 3(b).

When the detection part 502 has detected that the wafer W has arrived at the fourth position 404, the controller 500 causes the raising/lowering drive part 511 to apply a positive pressure to the suction portions 245 of the raising/lowering portion 240. Accordingly, suction of the wafer W by the suction portions 245 is canceled and the wafer W is detached from the suction portions 245. Then, the controller 500 drives the inverting unit drive part 506 to apply a negative pressure to the wafer W. Accordingly, a state in which the wafer W is suctioned by the suction portions 111 of the inverting unit 100 is established.

The controller 500 drives the inverting unit drive part 506 to cause the inverting unit 100 to invert the front and back faces of the wafer W and simultaneously convey the wafer W to the second position 402. This corresponds to the conveyance route indicated by the arrow 417 in FIG. 3(b).

In step S20, when the detection part 502 has detected that the wafer W has arrived at the second position 402, the controller 500 causes the inverting unit drive part 506 to apply a positive pressure to the suction portions 111 of the inverting unit 100. Accordingly, suction of the wafer W by the suction portions 111 is canceled, and the wafer W is detached from the suction portions 111. Then, the controller 500 causes the third conveyance drive part 510 to drive the third conveyance portion 230, to operate the arm 233 of the third conveyance portion 230 such that the suction portions 231 come into contact with the surface WA of the wafer W. When the suction faces 231a of the suction portions 231 have come into contact with the surface WA of the wafer W, the third conveyance drive part 510 applies a negative pressure to the suction portions 231, to cause the wafer W to be suctioned by the suction portions 231. Accordingly, the wafer W is held by the third conveyance portion 230. Then, the third conveyance drive part 510 drives the third conveyance portion 230 to convey the wafer W to the first position 401. This corresponds to the conveyance route indicated by the arrow 421 in FIG. 3(a).

While the wafer W is conveyed from the second position 402 to the first position 401, the film 31 attached to the surface WA of the wafer W may be peeled.

When the detection part 502 has detected that the wafer W has arrived at the first position 401, the controller 500 causes the third conveyance drive part 510 to apply a positive pressure to the suction portions 231 of the third conveyance portion 230. Accordingly, suction of the wafer W by the suction portions 231 is canceled, and the wafer W is detached from the suction portions 231. Then, the controller 500 causes the first conveyance drive part 508 to drive the first conveyance portion 210, to convey the wafer W to the storage part 10. This corresponds to the conveyance route indicated by the arrow 422 in FIG. 3(a).

In step S20, while the wafer W has not yet arrived at the storage part 10, the controller 500 causes the wafer sending-in/sending-out drive part 503 to open the door of the storage part 10, and causes a sending-out part (not shown) to store the wafer W into the wafer breaking apparatus 1.

In step S21, the controller 500 determines whether or not there is a wafer W to be broken. When there is a wafer W to be broken (S21; YES), operations of the above steps S11 to S20 are repeatedly executed. When there is no wafer W to be broken (S21; NO), breaking of a wafer W by the wafer breaking apparatus 1 ends.

FIG. 14 is a block diagram specifically showing a configuration of the inverting unit 100 included in the wafer breaking apparatus 1 shown in FIG. 12. As described above, the inverting unit 100 includes the holding part 110, the rotation drive part 120, and the adjustment mechanism 130, and further includes, as shown in FIG. 14, a pressure application part 514, an air cylinder drive part 515, and a drive part 516. In FIG. 14, the controller 500, the input part 501, and the detection part 502 shown in FIG. 12 are also shown. These have been described with reference to FIG. 12.

FIG. 15 is a flow chart specifically describing the inversion operation of a wafer W in step S16 in the flow chart shown in FIG. 13. This control is executed by the controller 500 shown in FIG. 13 and FIG. 15.

In FIG. 15, "START" is the time point at which attachment of the film 31 to the surface WA of the wafer W by the film laminating unit 30 is completed in step S15 shown in FIG. 13.

In step S31, the controller 500 causes the raising/lowering drive part 511 to drive the raising/lowering portion 240, so as to drive the raising/lowering portion 240 such that the suction faces 245a of the suction portions 245 come into contact with the surface WA of the wafer W. When the suction faces 245a of the suction portions 245 have come into contact with the surface WA of the wafer W, the raising/lowering drive part 511 applies a negative pressure to the suction portions 245 to cause the wafer W to be suctioned by the suction portions 245. Accordingly, the wafer W is held by the raising/lowering portion 240. Then, the raising/lowering drive part 511 drives the raising/lowering portion 240 to be conveyed to the fourth position 404, i.e., the reception position. This corresponds to the conveyance route indicated by the arrow 416 in FIG. 3(b).

When the detection part 502 has detected that the wafer W has arrived at the fourth position 404, the controller 500 causes the raising/lowering drive part 511 to apply a positive pressure to the suction portions 245 of the raising/lowering portion 240. Accordingly, suction of the wafer W by the suction portions 245 is canceled, and the wafer W is detached from the suction portions 245.

In step S32, the controller 500 drives the inverting unit drive part 506 to apply a negative pressure to the wafer W. Accordingly, a state in which the wafer W is suctioned by the suction portions 111 of the inverting unit 100 is established.

In step S33, the controller 500 causes the drive part 516 to apply a driving force to the rotation drive part 120. The drive part 516 is a motor, for example. Accordingly, the drive mechanism 121 causes the support member 122 to linearly move to the Z-axis negative side. Simultaneously with this movement of the support member 122, the pinion gear 123 is rotated on the rack gear 124. Accordingly, the rotation shaft 123a of the holding part 110 is rotated in the Z-axis negative side direction, and the holding part 110 is moved from the third position 403 toward the inversion completion position 407. When the holding part 110 has arrived at the inversion completion position 407, inversion of the front and back faces of the wafer W is completed. This corresponds to the states shown in FIGS. 6(a) to 6(c).

In step S34, the controller 500 determines, by means of the detection part 502, whether or not the wafer W is positioned at the inversion completion position 407. When the detection part 502 has detected that the wafer W is positioned at the inversion completion position 407 (S34; YES), the controller 500 causes the air cylinder drive part 515 to reduce the pressure applied to the air cylinder 134 and causes the drive part 516 to stop applying the driving force to the rotation drive part 120. When the wafer W is not yet positioned at the inversion completion position 407 (S34; NO), the controller 500 continuously causes the drive part 516 to apply a driving force to the rotation drive part 120.

In step S35, when the air cylinder drive part 515 has reduced the pressure applied to the air cylinder 134 to a predetermined value, the moving member 131 starts linear movement from the inversion completion position 407 toward the second position 402 against the biasing force by the air cylinder 134. This corresponds to the states shown in FIGS. 8(a) and 8(b).

In step S36, the controller 500 determines, by means of the detection part 502, whether or not the wafer W is positioned at the second position 402. When the detection part 502 has detected that the wafer W is positioned at the second position 402 (S36; YES), the controller 500 causes the pressure application part 514 to apply a positive pressure to the suction portions 111 of the holding part 110. Accordingly, suction of the wafer W by the suction portions 111 is canceled, and the wafer W is separated from the suction faces 111a. As described in step S16 in FIG. 13, while the wafer W is inverted, the break table 41 stands by at the second position 402. Thus, the inverted wafer W is placed on the break table 41. When the wafer W is not yet positioned at the second position 402 (S36; NO), the controller 500 continuously controls the air cylinder drive part 515 so as to reduce the pressure of the air cylinder 134. Then, the inversion operation of the wafer W ends.

In the above description, after step S19, the wafer W is conveyed to the storage part 10. Here, for example, when the surface WA of the wafer W is coated with a metal film, sufficient cracks cannot be formed in the wafer W in the process of step S17 and the wafer W cannot be broken in some cases. Therefore, in step S19, with the surface WA positioned on the upper side, the wafer W may be conveyed to the break unit 40 again to break the surface WA. After the surface WA of the wafer W has been broken by the break unit 40, the wafer W is conveyed via the second position 402 to the storage part 10.

### <Effects of embodiment>

According to the embodiment, the following effects are exhibited.

As shown in FIGS. 1, 2, and FIG. 3(b), the film laminating unit 30 is disposed above the other units. Usually, the film laminating unit 30 has a larger area than the scribe unit 20 and the break unit 40. Therefore, since the film laminating unit 30 is disposed in an upper portion, the installation area of the entirety of the apparatus can be reduced. In this arrangement, a conveyance path for conveying a wafer W to the film laminating unit 30 need not be provided on a plane. Thus, the installation area can be further reduced by the area corresponding to members related to such a conveyance path. Accordingly, the operating rate per installation area of the apparatus can be improved.

In the present embodiment, in particular, the film laminating unit 30 is disposed above the inverting unit 100 in the vertical direction. Since the film laminating unit 30 and the inverting unit 100 are arranged on one straight line, the route for conveying a wafer W can be easily configured. Therefore, the wafer W can be efficiently conveyed from the film laminating unit 30 to the inverting unit 100.

The delivery position is provided immediately below the inverting unit 100 and between the scribe unit 20 and the break unit 40. Thus, a wafer W to which the film 31 has been attached can be conveyed in a conveyance route in a single direction extending downwardly. In addition, when the wafer W is conveyed downwardly, the wafer W can be positioned to the delivery position also due to gravity. Therefore, conveyance of the wafer from the inverting unit 100 to the delivery position can be smoothly and efficiently performed.

The film laminating unit 30 and the inverting unit 100 may be arranged below the second position 402. Also with such an arrangement, the same effects as above can be exhibited in terms of reduction of the installation area of the apparatus. However, when the film laminating unit 30 and the inverting unit 100 are arranged above the delivery position, the conveyance route can be more simplified and the action of gravity can be also used. Thus, inversion of the wafer W can be more smoothly performed.

Conventional inverting units are often configured to once raise/lower a wafer in order to invert the wafer, rotate (invert) the wafer by 180° at an upper position, and then cause another gripping member or the like to grip the wafer, to place the wafer at a predetermined position. Such a configuration requires areas in the vertical and horizontal directions, and requires a shaft for raising/lowering the wafer, a shaft for rotating the wafer, and still another gripping portion, which results in a large apparatus. In addition, since various steps are included, inversion operation takes time.

In this regard, as shown in FIG. 4 to FIG. 8(b), the inverting unit 100 of the present embodiment can convey a wafer W to an intended position while inverting the wafer W. Thus, the size of the inverting unit 100 itself can be reduced, and as a result, the area of the entirety of the wafer breaking apparatus 1 can be reduced. Since the time required for the inversion operation is also shortened, the operating rate of the apparatus can be improved.

As shown in FIG. 11, when the wafer W is at a position to which the wafer W has been rotated 90° from the fourth position 404 to the X-axis negative side by the inverting unit 100, a space is generated between the fourth position 404 and the second position 402. Therefore, the arm 243 of the raising/lowering portion 240 can be caused to pass through this space to convey the wafer W positioned at the second position 402.

As shown in FIG. 3(a), the wafer W broken by the break unit 40 is returned to the storage part 10. Thus, the conveyance route can be used in common before and after the breakage of the wafer W. Therefore, the area required for provision of the conveyance route can be suppressed, and thus, the installation area of the apparatus can be reduced.

As shown in FIGS. 4 and 5, through the combination of the support member 122 that is moved in a linear direction, and the pinion gear 123 and the rack gear 124, the inverting unit 100 can cause the wafer W to be rotated while causing the holding part 110 to be linearly moved. Thus, the front and back faces of the wafer W can be inverted with a simple configuration.

As shown in FIG. 6(a) to FIG. 7, the inversion completion position 407 and the second position 402 are separated from each other. Therefore, the wafer W does not come into contact with the second position 402 during inversion operation, and thus, the wafer W can be prevented from being damaged.

As shown in FIGS. 8(a) and 8(b), when the support member 122 is linearly moved and the bolt 135 provided to the support member 122 comes into contact with the flange portion 136, the predetermined pressure applied to the air cylinder 134 is reduced. Accordingly, the pressing force by the support member 122 on the moving member 131 exceeds the biasing force by the air cylinder 134. This allows the moving member 131 to move along the guide 132 in a sliding manner against the biasing force by the air cylinder 134.

In this case, since the moving member 131 has the rack gear 124 coupled thereto, the support member 122, the pinion gear 123, the rack gear 124, and the moving member 131 are integrally moved from the inversion completion position 407 to the second position 402. Thus, no relative movement is caused between the pinion gear 123 and the rack gear 124, and therefore, further rotation of the wafer W does not occur during the movement from the inversion completion position 407 to the second position 402. Accordingly, the wafer W can be smoothly moved from the inversion completion position 407 to the second position 402.

In the above embodiment, the holding part 110 is provided with the suction portions 111 to suction the wafer W. However, a gripping portion that grips the wafer W may be provided.

As shown in FIGS. 3(a) and 3(b) and FIGS. 6(a) to 6(c), the wafer W is delivered from the fourth position 404 at an upper position to the second position 402 at a lower position. However, the inverting unit 100 can also hold, through suction, the wafer W placed at the second position 402, and invert the wafer W while moving the wafer W from the second position 402 toward the fourth position 404 at an upper position.

As shown in FIGS. 8(a) and 8(b), since the air cylinder 134 is used as a biasing member, biasing of the moving member 131 can be smoothly controlled.

In the above embodiment, the lever 114 is mounted to the rotation shaft 123a. However, without the lever 114 being provided, the holding member 113 may be directly mounted to the rotation shaft 113a. In this case, since the lever 114 is not provided, an arc-shaped trajectory made by the wafer W being rotated is small. In this case, the space that allows passage of the arm 243 of the raising/lowering portion 240 is not generated between the inversion completion position 407 and the fourth position 404, which is the reception position at which the inverting unit 100 receives the wafer W. This allows reduction in the size of the inverting unit 100 although the wafer W placed at the inversion completion position 407 cannot be sent out by the raising/lowering portion 240.

When the inverting unit 100 and the conveyance part 200 described above are combined together, a conveyance system in which the wafer W is inverted and conveyed can be formed.

Various modifications can be made as appropriate to the embodiment of the present invention, without departing from the scope of the technological idea defined by the claims.

### DESCRIPTION OF THE REFERENCE CHARACTERS

- 1: wafer breaking apparatus
- 10: storage part
- 20: scribe unit
- 30: film laminating unit
- 31: film
- 40: break unit
- 100: inverting unit
- 200: conveyance part
- 240: raising/lowering portion
- 402: second position (delivery position)
- 404: fourth position (reception position)
- 407: inversion completion position
- W: wafer
- WA: front face of wafer
- WB: back face of wafer

## Claims

1. A wafer breaking apparatus comprising:
a scribe unit configured to form a scribe line on a surface of a wafer;
a film laminating unit configured to attach a film to the surface, of the wafer, on which the scribe line has been formed;
an inverting unit configured to invert the wafer such that a face, of the wafer, to which the film has been attached is on a lower side;
a break unit configured to break the wafer along the scribe line by applying a predetermined force to a face, of the wafer, to which the film has not been attached; and
a conveyance part configured to convey the wafer to a predetermined position, wherein
the film laminating unit is disposed at a position separated in a vertical direction from the inverting unit.

2. The wafer breaking apparatus according to claim 1, wherein
the wafer is sent to a delivery position provided at a position, in a plan view, that is between the scribe unit and the break unit and that is overlapped by the inverting unit, and
the conveyance part includes a raising/lowering portion configured to convey the wafer positioned at the delivery position to the film laminating unit, and further configured to convey the wafer from the film laminating unit to the inverting unit.

3. The wafer breaking apparatus according to claim 2, wherein
while inverting the wafer to which the film has been attached by the film laminating unit, the inverting unit conveys the wafer to the delivery position.

4. The wafer breaking apparatus according to claim 2 or 3, wherein
the wafer broken by the break unit is conveyed via the delivery position to a position at which conveyance of the wafer has been started.

5. The wafer breaking apparatus according to any one of claims 2 to 4, wherein
the inverting unit is disposed above the delivery position.

6. The wafer breaking apparatus according to claim 5, wherein
the film laminating unit is disposed above the inverting unit.

7. The wafer breaking apparatus according to any one of claims 1 to 6, wherein
the inverting unit includes:
a holding part configured to hold the wafer; and
a rotation drive part configured to move the holding part in a linear direction while rotating the holding part, and
the rotation drive part drives the holding part such that the wafer is rotated such that front and back faces thereof are reversed while the wafer is making an arc-shaped trajectory, between a reception position at which the holding part receives the wafer and an inversion completion position that is separated in the linear direction from the reception position and at which inversion of the wafer is completed.

8. The wafer breaking apparatus according to claim 7, wherein
the rotation drive part includes:
a support member configured to rotatably support the holding part;
a pinion gear mounted to a rotation shaft of the holding part;
a rack gear meshed with the pinion gear and extending in the linear direction; and
a drive mechanism configured to move the support member in the linear direction.

9. The wafer breaking apparatus according to claim 8, wherein
the wafer taken out of the storage part is sent to a delivery position provided at a position, in a plan view, that is between the scribe unit and the break unit and that is overlapped by the inverting unit,
after the wafer has been transferred from the reception position to the inversion completion position, the drive mechanism further moves the support member by a predetermined number of strokes to transfer the wafer to the delivery position separated in the linear direction from the inversion completion position, and
the wafer breaking apparatus further includes an adjustment mechanism configured to move the rack gear in the linear direction in association with the movement of the support member by the predetermined number of strokes.

10. The wafer breaking apparatus according to claim 9, wherein
the adjustment mechanism includes:
a moving member coupled to the rack gear;
a guide configured to support the moving member so as to be movable in a sliding manner in the linear direction;
a biasing member configured to bias the moving member in a direction from the inversion completion position toward the reception position; and
a sending mechanism configured to move the moving member against the biasing by the biasing member during the movement of the support member by the predetermined number of strokes.

11. The wafer breaking apparatus according to claim 10, wherein
the sending mechanism includes:
a contacted part provided to the moving member; and
a contacting part provided to the support member and opposed to the contacted part in the linear direction, and
during the movement of the support member by the predetermined number of strokes, the contacting part comes into contact with the contacted part, the moving member receives a pressing force from the support member, and due to the pressing force, the moving member is moved against the biasing in association with the movement of the support member.

12. The wafer breaking apparatus according to claim 10 or 11, wherein
the biasing member is an air cylinder.

13. The wafer breaking apparatus according to any one of claims 8 to 12, wherein
the reception position is at an upper position in the vertical direction relative to the inversion completion position.

14. The wafer breaking apparatus according to any one of claims 8 to 13, wherein
the holding part includes:
a suction portion configured to suction the wafer;
a lever mounted to the rotation shaft; and
a holding member coupled to the lever and configured to hold the suction portion.

15. The wafer breaking apparatus according to any one of claims 8 to 13, wherein
the holding part includes:
a suction portion configured to suction the wafer; and
a holding member mounted to the rotation shaft and configured to hold the suction portion.

16. The wafer breaking apparatus according to claims 7 to 15, wherein
the conveyance part includes a conveyance member configured to be raised/lowered in the linear direction, and
when the holding part is at a position to which the holding part has been rotated by 90° from the reception position, the conveyance member passes between the reception position and the inversion completion position in the linear direction.

17. An inverting apparatus configured to invert a wafer, the inverting apparatus comprising:
a holding part configured to hold the wafer; and
a rotation drive part configured to move the holding part in a linear direction while rotating the holding part, wherein
the rotation drive part drives the holding part such that the wafer is rotated such that front and back faces thereof are reversed while the wafer is making an arc-shaped trajectory, between a reception position at which the holding part receives the wafer and an inversion completion position that is separated in the linear direction from the reception position and at which inversion of the wafer is completed.

18. The inverting apparatus according to claim 17, wherein
the rotation drive part includes:
a support member configured to rotatably support the holding part;
a pinion gear mounted to a rotation shaft of the holding part;
a rack gear meshed with the pinion gear and extending in the linear direction; and
a drive mechanism configured to move the support member in the linear direction.

19. The inverting apparatus according to claim 18, wherein
after the wafer has been transferred from the reception position to the inversion completion position, the drive mechanism further moves the support member by a predetermined number of strokes to transfer the wafer to a delivery position separated in the linear direction from the inversion completion position, and
the inverting apparatus further includes an adjustment mechanism configured to move the rack gear in the linear direction in association with the movement of the support member by the predetermined number of strokes.

20. The inverting apparatus according to claim 19, wherein
the adjustment mechanism includes:
a moving member coupled to the rack gear;
a guide configured to support the moving member so as to be movable in a sliding manner in the linear direction;
a biasing member configured to bias the moving member in a direction from the inversion completion position toward the reception position; and
a sending mechanism configured to move the moving member against the biasing by the biasing member during the movement of the support member by the predetermined number of strokes.

21. The inverting apparatus according to claim 20, wherein
the sending mechanism includes:
a contacted part provided to the moving member; and
a contacting part provided to the support member and opposed to the contacted part in the linear direction, and
during the movement of the support member by the predetermined number of strokes, the contacting part comes into contact with the contacted part, the moving member receives a pressing force from the support member, and due to the pressing force, the moving member is moved against the biasing in association with the movement of the support member.

22. The inverting apparatus according to claim 20 or 21, wherein
the biasing member is an air cylinder.

23. The inverting apparatus according to any one of claims 18 to 22, wherein
the reception position is at an upper position in a vertical direction relative to the inversion completion position.

24. The inverting apparatus according to any one of claims 18 to 23, wherein
the holding part includes:
a suction portion configured to suction the wafer;
a lever mounted to the rotation shaft; and
a holding member coupled to the lever and configured to hold the suction portion.

25. The inverting apparatus according to any one of claims 18 to 23, wherein
the holding part includes:
a suction portion configured to suction the wafer; and
a holding member mounted to the rotation shaft and configured to hold the suction portion.

26. A conveyance system configured to convey a wafer, the conveyance system comprising:
an inverting apparatus including
a holding part configured to hold the wafer and
a rotation drive part configured to move the holding part in a linear direction while rotating the holding part, the rotation drive part being configured to drive the holding part such that the wafer is rotated such that front and back faces thereof are reversed while the wafer is making an arc-shaped trajectory, between a reception position at which the holding part receives the wafer and an inversion completion position that is separated in the linear direction from the reception position and at which inversion of the wafer is completed; and
a conveyance apparatus configured to convey the wafer to the inverting unit.

27. The conveyance system according to claim 26, wherein
the conveyance apparatus includes a conveyance member configured to be raised/lowered in the linear direction, and
when the holding part is at a position to which the holding part has been rotated by 90° from the reception position, the conveyance member passes between the reception position and the inversion completion position in the linear direction.
